(19) Europäisches Patentamt / European Patent Office / Office européen des brevets

(11) **EP 3 776 871 B1**

(12) **FASCICULE DE BREVET EUROPEEN**

(45) Date de publication et mention
de la délivrance du brevet:
**06.12.2023 Bulletin 2023/49**

(21) Numéro de dépôt: **19715525.2**

(22) Date de dépôt: **10.04.2019**

(51) Classification Internationale des Brevets (IPC):
**H03M 13/37** *(2006.01)* **G06F 11/10** *(2006.01)*

(52) Classification Coopérative des Brevets (CPC):
**H03M 13/373; H03M 13/3761**

(86) Numéro de dépôt international:
**PCT/EP2019/059119**

(87) Numéro de publication internationale:
**WO 2019/197482 (17.10.2019 Gazette 2019/42)**

(54) **RÉCUPÉRATION D'EFFACEMENT DANS UN SYSTÈME DE STOCKAGE DISTRIBUÉ**

WIEDERHERSTELLUNG VON AUSLÖSCHUNGEN IN EINEM VERTEILTEN SPEICHERSYSTEM

ERASURE RECOVERY IN DISTRIBUTED STORAGE SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.04.2018 FR 1853246**

(43) Date de publication de la demande:
**17.02.2021 Bulletin 2021/07**

(73) Titulaire: **Institut Mines Telecom**
**91120 Palaiseau (FR)**

(72) Inventeurs:
• **BACCOUCH, Hana**
**92400 Courbevoie (FR)**
• **BOUKHATEM, Nadia**
**75013 Paris (FR)**

(74) Mandataire: **Atout PI Laplace**
**Immeuble "Visium"**
**22, avenue Aristide Briand**
**94117 Arcueil Cedex (FR)**

(56) Documents cités:
**CN-A- 107 844 272      US-A1- 2011 141 141**
**US-A1- 2013 054 549      US-A1- 2016 211 869**

• **CHENG HUANG ET AL: "Erasure Coding in Windows Azure Storage", USENIX,, 11 avril 2013 (2013-04-11), pages 1-12, XP061013941,**
• **CHENG HUANG ET AL: "Pyramid Codes: Flexible Schemes to Trade Space for Access Efficiency in Reliable Data Storage Systems", PROC. SIXTH IEEE INTERNATIONAL SYMPOSIUM ON NETWORK COMPUTING AND APPLICATIONS 2007, IEEE, 1 juillet 2007 (2007-07-01), pages 79-86, XP031119281, ISBN: 978-0-7695-2922-6**

EP 3 776 871 B1

**Description**

**Domaine de l'invention**

L'invention s'inscrit dans le domaine général des systèmes de stockage de données et la gestion des pannes dans ces systèmes. Plus particulièrement, l'invention concerne des méthodes et dispositifs de codage et de décodage de données permettant d'optimiser les opérations de lecture/écriture de données et d'optimiser le volume de données à transférer, nécessaires à la réparation d'un système de stockage suite à une panne.

**Etat de la Technique**

Au cours des dernières années, le volume de données numériques a augmenté considérablement, en raison de l'utilisation d'applications comme les réseaux sociaux, les e-mails, le partage de fichiers, de vidéos. Ainsi, les entreprises proposant des services en ligne, doivent gérer des volumes de données de plusieurs dizaines de pétabytes (1 PB = $10^{15}$ octets). Ces quantités de données qui ne cessent d'augmenter de façon exponentielle année après année, nécessitent d'être stockées de manière fiable.

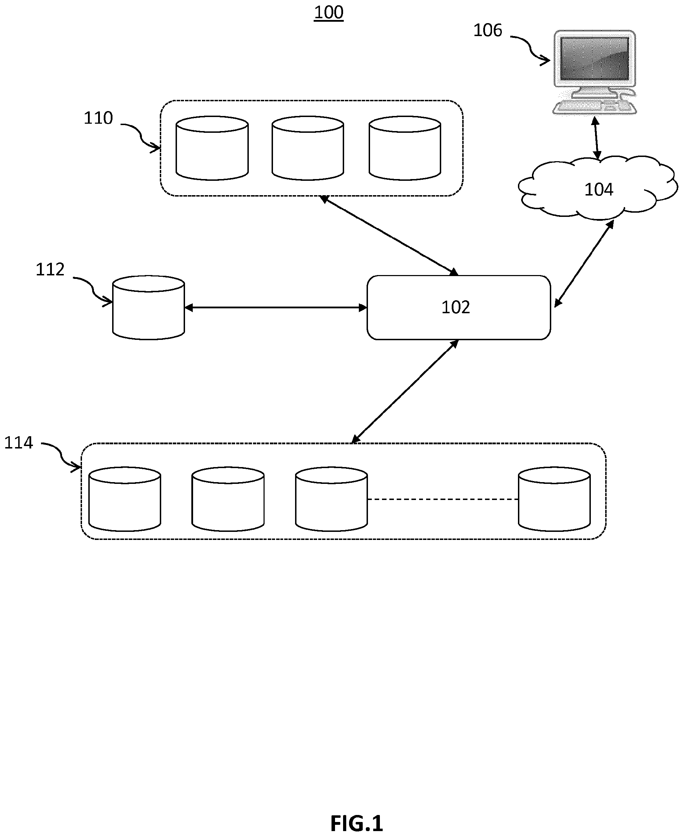

Les systèmes de stockage distribués ou (DSS) pour « Distributed Storage Systems » sont largement utilisés aujourd'hui pour fournir des solutions de stockage évolutives et fiables. Ces architectures tel qu'illustré sur la figure 1 comprennent de multiples noeuds de stockage (110, 112, 114) où des données sont stockées de manière distribuée. Un noeud de stockage peut être composé d'un (112) ou d'une pluralité d'équipements de stockage (110, 114). Chaque équipement de stockage d'un noeud qui en comporte plusieurs est lui-même désigné comme un noeud de stockage. En général, les équipements de stockage sont des disques de stockage. Un contrôleur (102) permet de gérer les communications de/vers les noeuds, dont les opérations de lecture/écriture disque à partir de requêtes reçues depuis un ordinateur (106) couplé au réseau de communication (104).

Or, il n'est pas rare que des disques, des équipements ou des noeuds de stockage tombent en panne, et il est courant que pour des milliers de noeuds, quelques dizaines de pannes en moyenne sont reportées par jour. Un système de stockage distribué doit assurer la protection des données dans le cas où un ou plusieurs noeuds ou équipements de stockage ou disques tombent en pannent.

Afin d'assurer la fiabilité et la disponibilité des données, les implémentations standard intègrent des solutions basées sur la redondance des données afin de pouvoir récupérer les données perdues en cas de panne.

Il existe plusieurs méthodes, listées ci-après, permettant d'apporter une fiabilité à un système de stockage :
La Réplication est une des méthodes les plus répandues. Elle consiste à répliquer un même bloc de données sur plusieurs noeuds de stockage. Généralement, un même bloc de données est stocké dans n noeuds différents, ce qui permet de tolérer n-1 pannes. En pratique, chaque bloc de données est stocké dans trois noeuds différents permettant de tolérer deux pannes. Même si la réplication offre une bonne tolérance aux pannes, elle a le désavantage d'afficher un surcoût de stockage ou « overhead » en anglais, qui peut être évalué à 200% dans les réplications à 3 noeuds.

Le Code d'effacement ou « Erasure Code ». Cette approche est basée sur l'utilisation des codes bien connus Reed-Solomon (RS). Chaque fichier de donnée est décomposé en k blocs de données auxquels sont ajoutés r blocs fonctions de parité générant k+r blocs de données, et l'on parle de code RS(k,r). Les k+r blocs de données sont stockés dans k+r noeuds différents, où k noeuds stockent les k blocs originaux et r noeuds de parité stockent les r blocs fonctions de parité. Un code RS(k,r) a deux propriétés de base: n'importe quel bloc k de données parmi les k+r blocs est suffisant pour régénérer la donnée originelle, et r pannes, quelles qu'elles soient, peuvent être tolérées. En pratique, avec un code RS(10,4), chaque fichier de données est décomposé en 10 blocs, et 4 blocs fonctions de parité sont générés, permettant de tolérer jusqu'à quatre pannes. Les codes RS offrent une meilleure efficacité de stockage par rapport à la réplication, le surcoût de stockage étant évalué à 40% pour un code RS(10,4).

Dans un système de stockage de données, en cas de panne, la reconstruction des données nécessite la lecture des données stockées dans les noeuds de redondance, puis leur transfert dans le réseau depuis ces noeuds fournisseurs de données, aussi appelés « providers » en anglais, dans un nouveau noeud de stockage, aussi appelé « newcomer » en anglais. Même si en cas de panne d'un seul noeud, il n'y a besoin que d'un seul fournisseur dans le cas de la réplication, il faut k fournisseurs dans le cas d'un code RS(k,r), impliquant alors le transfert sur le réseau des données des k fournisseurs. La réparation d'une seule panne peut ainsi nécessiter la lecture et la transmission de centaines de térabytes (TB). Aussi, le coût de la réparation en termes de bande-passante et de lectures/écritures peut être significatif.

Certaines solutions listées ci-dessous, s'intéressent à la réduction de la bande-passante requise pendant la phase de réparation ou « bandwidth repair » en anglais.

Les codes régénérateurs sont un exemple. L'idée principale telle que décrite dans l'article « Network coding for distributed storage systems », Alexandros G Dimakis, P Brighten Godfrey, Yunnan Wu, Martin J Wainwright, and Kannan Ramchandran, IEEE Transactions on Information Theory, 56(9): 4539-4551, 2010, est que chaque noeud génère une combinaison linéaire de données à partir des blocs de données qui y sont disponibles. La quantité de données à transférer à partir de chaque noeud fournisseur est alors plus faible que celle stockée dans chaque noeud, ce qui réduit la bande-passante nécessaire pour la réparation. Cependant, avec un code régénérateur, l'information récupérée dans le nouveau noeud est une combinaison linéaire des données transférées, et elle peut alors ne pas être forcément égale au bloc de données perdu.

Les codes régénérateurs exacts sont proposés pour récupérer exactement le même bloc de données perdu. L'idée principale telle que décrite dans l'article « Optimal exact-regenerating codes for distributed storage at the MSR and MBR points via a product-matrix construction », Rashmi, Korlakai Vinayak, Nihar B. Shah, and P. Vijay Kumar, IEEE Transactions on Information Theory 57(8): 5227-5239, 2011, consiste à éliminer les blocs de données non désirés en utilisant le concept d'alignement d'interférences. Même si les codes régénérateurs exacts permettent de réduire considérablement la bande passante pour la réparation, le coût des entrées/sorties disque (« I/O overhead ») n'est pas optimisé. En effet, pour réparer une seule panne, un code régénérateur exact nécessite de lire toutes les données stockées dans tous les noeuds.

Des solutions sont proposées pour réduire à la fois la bande passante de réparation et le coût des entrées/sorties disque.

Par exemple, avec les codes Hiérarchiques tels que présentés dans l'article « Hierarchical codes: How to make erasure codes attractive for peer-to-peer storage systems », Alessandro Duminuco and Ernst Biersack, P2P'08, 8th IEEE International Conférence on Peer-to-Peer Computing, pages 89-98, l'idée principale consiste à créer de manière hiérarchique, des fonctions de parité spécifiques à partir de codes plus petits que le code original. Un code Hiérarchique (k,r) a besoin de $\lfloor k/r\text{-}1 \rfloor$ (partie entière de k/r-1) à k blocs de données lues et téléchargées pour réparer une seule panne. Cependant, le code Hiérarchique ne maintient pas toutes les propriétés d'un code RS classique. En effet, un code Hiérarchique (k,r) ne peut tolérer r pannes quelconques. Il s'avère donc moins fiable à redondance égale.

Le code Hitchhicker est un code qui permet de maintenir les mêmes propriétés qu'un code RS et d'offrir une réparation de panne moins coûteuse en termes de bande passante et d'entrées/sorties disque. L'idée principale telle que décrite dans « A hitchhiker's guide to fast and efficient data reconstruction in erasure-coded data centers», KV Rashmi, Nihar B Shah, Dikang Gu, Hairong Kuang, Dhruba Borthakur, and Kannan Ramchandran, ACM SIGCOMM Computer Communication Review, 44(4):331-342, 2015, consiste à réduire le nombre de blocs de données nécessaires pour réparer une seule panne. L'approche Hitchhicker considère deux sous-codes RS ayant la même configuration (k,r). Des fonctions de parités spécifiques qui dépendent du deuxième et du premier code sont créées dans le deuxième sous-code RS. Ces fonctions de parité entrelacées permettent de réduire la quantité de données lues et transférées pour réparer un bloc de données. Un code Hitchhiker (10,4) permet de réduire de 30% à 35% le coût de la bande-passante de réparation et des entrées/sorties disque.

Les références suivantes proposent des méthodes de codage de données pour réduire la bande passante :

- Cheng Huang et al. : « Erasure Coding in Windows Azure Storage », USENIX,, 11 avril 2013 (2013-04-11), pages 1-12, XP061013941. Cette méthode LRC (k, l, r) est basée sur la génération de fonctions de parité locales stockées dans des noeuds de stockage ; Cependant, les codes LRC introduisent un surcoût de stockage dû au stockage supplémentaire des fonctions de parité locales.
- Cheng Huang et al. : « Pyramid Codes : Flexible Schemes to Trade Spaces for Access Efficiency in Reliable Data Storage systems", Proc. Sixth IEEE International Symposium on Network Computing and Applications 2007, IEEE, 1 juillet 2007 (2007-0è-0&), pages 79-86, XP031119281, ISBN: 978-0-7695-2922-6. Cette méthode présente une alternative à la méthode LRC. Cependant, les codes Pyramid, comme les codes LRC, introduisent un surcoût de stockage comparé à un code d'effacement classique et au code Babylon.

Ces approches ne permettant pas une même efficacité de stockage qu'un code d'effacement classique. contrairement aux codes Hithchicker, aux codes régénérateurs et aux codes hiérarchiques qui permettent de réduire la bande passante tout en maintenant la même efficacité de stockage qu'un code d'effacement classique.

Contrairement aux méthodes décrites précédemment basées sur la définition d'un nouveau code d'effacement, la solution proposée dans la demande de brevet US 2016/211869 A1 de Blaum Mario et al. propose un système de stockage dynamique intégrant plusieurs codes d'effacement, capable de basculer entre différents codes en fonction de l'objectif. Le système décide soit de réduire la bande passante de réparation, soit de réduire le surcoût de stockage en fonction de la popularité du fichier. Le système supporte en particulier les deux codes : LRC (cité précédemment) et le « Product Code » (PC).

Il ressort qu'il existe le besoin d'une solution de codage/décodage de données pour la reconstruction de données perdues ou endommagées lors d'une panne d'un ou plusieurs éléments de stockage de données, qui soit améliorée en termes de coût de bande-passante de réparation et de coût d'entrées/sorties disque, tout en maintenant la même efficacité de stockage que les codes d'effacement classiques.

Par ailleurs, avec l'arrivée des disques SSD (Solid State Drive), les éléments de stockage sont de plus en plus rapides, et chaque disque peut générer plusieurs dizaines de Gigabits par seconde en lecture. Le débit des interfaces reliant les éléments de stockage est alors particulièrement critique et devient un goulot d'étranglement des systèmes de stockage. La réduction des flux à échanger en cas de reconstruction est donc particulièrement importante. Il existe ainsi le besoin d'une solution permettant d'optimiser la quantité de données à transférer lors de la réparation d'un système de stockage, suite à une panne.

La présente invention répond aux différents besoins précités.

**Résumé de l'invention**

La présente invention vise à pallier les limites des techniques connues en proposant des méthodes et dispositifs de codage et de décodage de données permettant d'optimiser la quantité de données transférées, ainsi que les opérations de lecture/écriture nécessaires pour la réparation d'un système de stockage, suite à une panne.

Avantageusement, la présente invention permet de réduire à la fois la bande-passante de réparation et les coûts d'entrées/sorties disque tout en maintenant des propriétés d'efficacité de stockage et de fiabilité où toutes les pannes r parmi k+r sont tolérées.

Un objet de la présente invention est relatif à une méthode de codage de données. En particulier, il est proposé une méthode de codage (k, r) de données telle que définie dans la revendication indépendante.

Des modes de réalisation alternatifs ou combinés de la méthode de codage sont définis dans les revendications dépendantes.

La méthode de codage de données de la présente invention est particulièrement adaptée pour distribuée des données sur des équipements de stockage en prévision de reconstruire des données perdues suite à une panne d'un équipement de stockage. Il est aussi revendiqué une méthode de stockage de k+r données comprenant au moins une étape consistant à stocker dans k équipements de stockage systématique $N_i$, $i \in \{1, .., k\}$, k blocs de données $a_i$, et à stocker dans r équipements de stockage de parité $N_i$, $i \in \{k+1, .., k+r\}$, r fonctions de parité, les r fonctions de parité étant obtenues selon la méthode de codage de données revendiquée.

L'invention couvre aussi un dispositif de codage de données comprenant des moyens pour mettre en oeuvre les étapes de la méthode de codage de données telle que revendiquée.

Un autre objet de la présente invention est relatif à une méthode de reconstruction ou duplication du contenu d'un équipement qui stocke des données codées selon la méthode de codage revendiquée. En particulier, il est exposé dans les revendications, une méthode de reconstruction du contenu d'un équipement de stockage parmi une pluralité d'équipements stockant k blocs de données $a_i$ dans k équipements de stockage systématique $N_i$, $i \in \{1, .., k\}$, et r fonctions de parité $f_j(a)$ dans r équipements de stockage de parité $N_i$, $i \in \{k+1, .., k+r\}$, les dits k blocs de données et r fonctions de parité étant obtenus selon la méthode de codage revendiquée.

L'invention couvre aussi un dispositif de reconstruction du contenu d'un équipement de stockage parmi une pluralité d'équipements stockant k blocs de données $a_i$ dans k équipements de stockage systématique $N_i$, $i \in \{1, .., k\}$, et r fonctions de parité $f_j(a)$ dans r équipements de stockage de parité $N_i$, $i \in \{k+1, .., k+r\}$, lesdits k blocs de données et r fonctions de parité étant obtenus selon la méthode de codage revendiquée, le dispositif comprenant des moyens pour mettre en oeuvre les étapes de la méthode de reconstruction du contenu d'un équipement de stockage revendiquée.

La présente invention peut être intégrée à des éléments matériel et/ou logiciel tels qu'un circuit intégré de type ASIC ou FPGA.

L'invention porte aussi sur un programme d'ordinateur qui comporte des instructions de code permettant d'effectuer les étapes de la méthode de codage revendiquée et/ou comprenant des instructions de code permettant d'effectuer les étapes de la méthode de reconstruction de contenu revendiquée, lorsque ledit programme est exécuté sur un ordinateur.

L'invention peut être disponible sur un support d'enregistrement lisible par un processeur sur lequel est enregistré un programme comportant des instructions de code pour l'exécution de la méthode de codage et/ou de la méthode de reconstruction de contenu telles que revendiquées.

Une utilisation avantageuse de la méthode de reconstruction de contenu revendiquée est dans un système de stockage distribué qui comprend une pluralité de noeuds de stockage de données aptes à stocker des données codées selon la méthode de codage revendiquée.

Une autre utilisation avantageuse de la méthode de reconstruction de contenu revendiquée est dans un système de stockage local qui comprend des disques de stockage de données aptes à stocker des données codées selon la méthode de codage revendiquées.

**Description des figures**

Différents aspects et avantages de l'invention vont apparaitre en appui de la description d'un mode préféré d'implémentation de l'invention mais non limitatif, avec référence aux figures ci-dessous :

La figure 1 illustre un environnement de système distribué permettant de mettre en oeuvre l'invention dans un mode de réalisation ;

La figure 2 montre une représentation du stockage des données dans un mode de réalisation de l'invention ;

La figure 3 illustre les étapes du procédé de codage de l'invention dans un mode de réalisation ;

La figure 4 illustre la génération d'un vecteur d'encodage primaire, selon les principes de l'invention ;

La figure 5 illustre la génération d'un vecteur d'encodage secondaire, selon les principes de l'invention ;

La figure 6 illustre la génération d'une fonction de parité primaire et d'une fonction de parité secondaire, selon les principes de l'invention ;

Les figures 7a à 7c illustrent les étapes de reconstruction de noeuds systématiques et de parité selon les principes de l'invention ;

La figure 8 est un tableau comparatif des performances de différents codes.

## Description détaillée de l'invention

Pour la suite de la description, l'expression 'noeud de stockage' est utilisée au sens générique et désigne une entité de stockage, que ce soit un disque unique ou un groupement d'équipements de stockage formant un noeud. Les modes de réalisation de l'invention décrits s'appliquent à toute variante de système de stockage distribué illustré sur la figure 1, qui n'est qu'un exemple d'environnement permettant de mettre en oeuvre l'invention. Ainsi cet exemple n'est pas limitatif et les principes décrits peuvent être appliqués pour tout autre environnement intégrant un système de stockage, distribué ou non, comme les systèmes en nuage ou « Cloud Systems » en anglais, les centres de données ou « Data Centers » en anglais, les systèmes de fichiers distribués ou « Distributed File Systems » en anglais, qu'ils soient basés sur des fichiers ou à objets. L'invention peut également s'appliquer à des systèmes de stockage non distribués comme les « Disk Arrays ». Par ailleurs, un noeud de stockage qui stocke des données issues de la donnée initiale est désigné « noeud systématique » et un noeud de stockage qui stocke une fonction de parité est désigné « noeud de parité ».

Afin de faciliter la compréhension des principes de l'invention, la méthode de codage est d'abord décrite sur un exemple particulier d'un code (k=10, r=4), puis est généralisée pour tout code (k, r).

Description de la méthode de codage sur l'exemple d'un code (10, 4) :

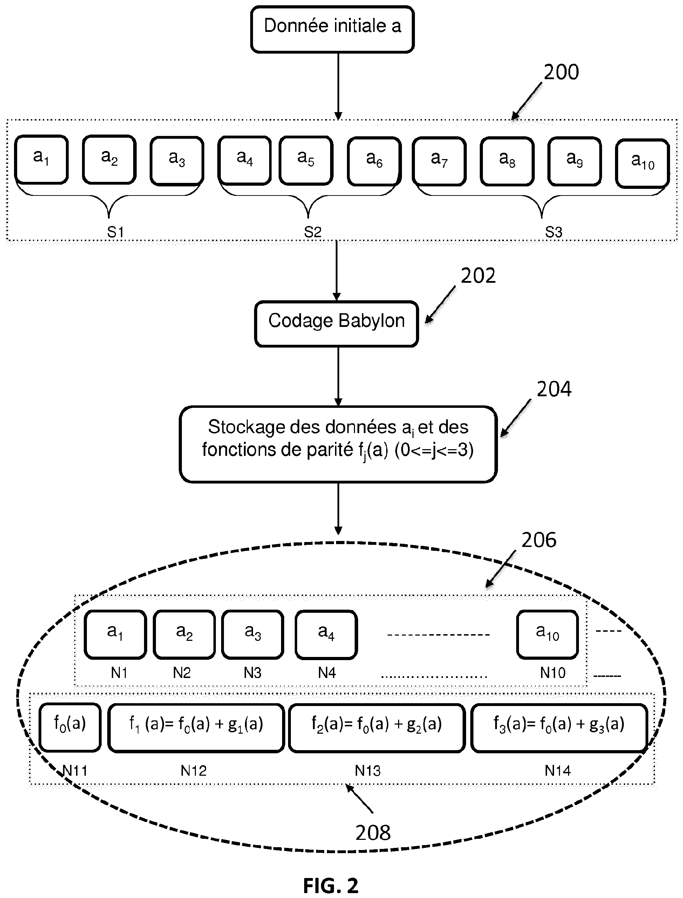

La figure 2 illustre une représentation du stockage de données par application de la méthode de codage de l'invention, sur l'exemple d'un code k=10 et r=4. Dans la suite de la description, les étapes de codage de la présente invention peuvent être désignées par l'expression « code Babylon » ou « codage Babylon ». Une donnée initiale a est divisée en k=10 morceaux (200) ou blocs de données $(a_1, ..., a_{10})$, notés $a_i$, $i \in \{1, .., 10\}$, auxquels sont ajoutés r=4 blocs de parité ou fonctions de parité $f_0$, $f_1$, $f_2$ et $f_3$, qui sont des combinaisons linéaires des données $(a_1, ..., a_{10})$ et notées dans la suite $f_0(a)$, $f_1(a)$, $f_2(a)$, $f_3(a)$ ou $f_0(a)$ et $f_j(a)$, $j \in \{1, 2, 3\}$. La fonction de parité $f_0(a)$ est désignée comme fonction de parité primaire, et les fonctions de parité $f_j(a)$ sont désignées comme fonctions de parité secondaires. Les fonctions de parité primaire et secondaires sont générées selon le codage Babylon (202) de l'invention et stockées sur des noeuds de stockage (204).

Les blocs de données systématiques $a_1$ à $a_{10}$ sont stockés sur 10 noeuds de stockage systématiques correspondants (206), notés $(N_1$ à $N_{10})$, et les fonctions de parité primaire $f_0(a)$ et secondaires $f_1(a)$, $f_2(a)$, $f_3(a)$ sont stockées sur 4 noeuds de stockage de parité correspondants (208), notés $N_{11}$ à $N_{14}$.

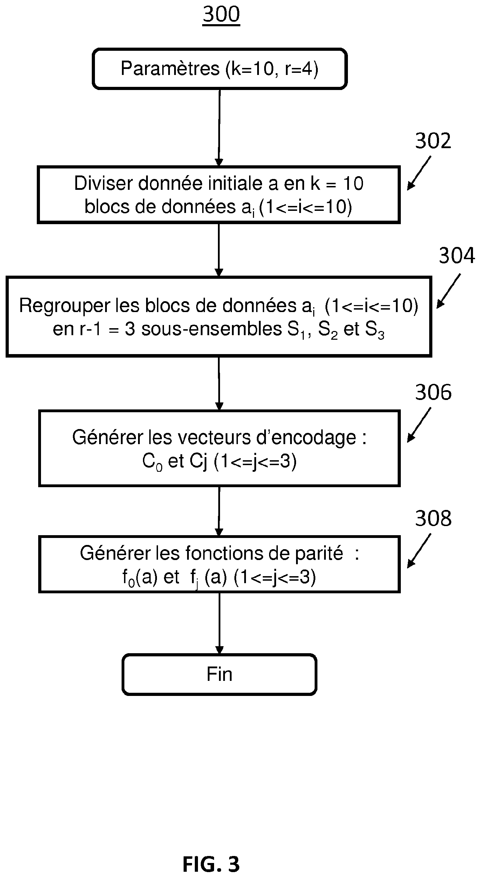

La figure 3 illustre les étapes du procédé de codage (300) de l'invention dans un mode de réalisation d'un code (k=10, r=4). Dans une première étape (302), le procédé permet de diviser une donnée initiale a en 10 blocs de données $(a_1, ..., a_{10})$, puis dans une étape suivante (304) de créer 3 sous-ensembles de données $(S_1, S_2, S_3)$. Chaque sous-ensemble de données regroupe des blocs de données différents parmi les 10 blocs créés. Dans un mode de réalisation, deux sous-ensembles $(S_1, S_2)$ sont composés chacun de 3 blocs de données et le troisième sous-bloc $(S_3)$ est composé de 4 blocs de données. Le premier sous-ensemble $S_1$ est composé des trois premiers blocs $(a_1, a_2, a_3)$ issus de la donnée initiale, le second sous-ensemble $S_2$ est composé des trois blocs suivants $(a_4, a_5, a_6)$, et le dernier sous-ensemble $S_3$ est composé des quatre derniers blocs restants $(a_7, a_8, a_9, a_{10})$.

Dans une étape suivante (306), le procédé permet de générer 4 vecteurs d'encodage de longueur (k=10), correspondants aux 4 noeuds de parité. Les vecteurs d'encodage notés $C_0$ à $C_4$, correspondent à un vecteur d'encodage primaire $C_0$ et 3 vecteurs d'encodage secondaires $C_1$, $C_2$, $C_3$.

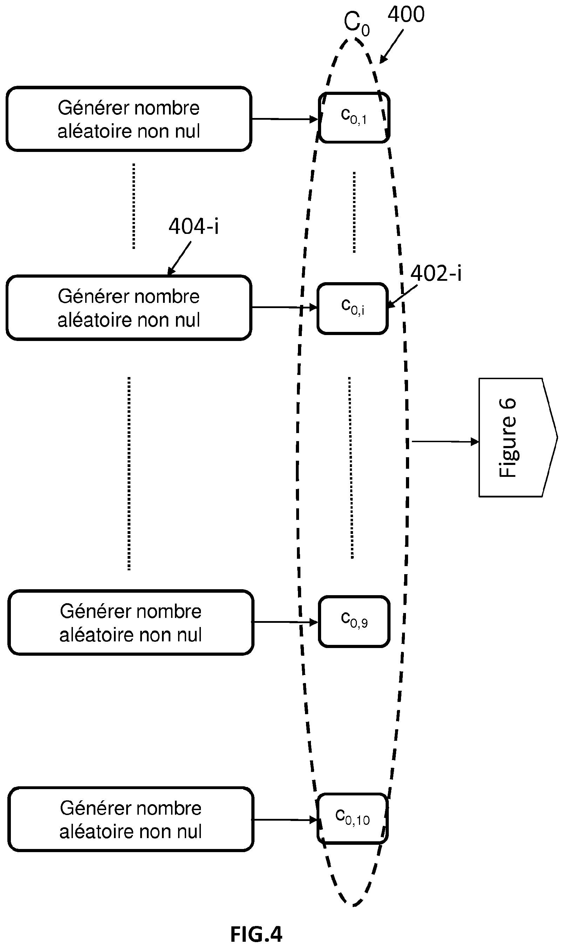

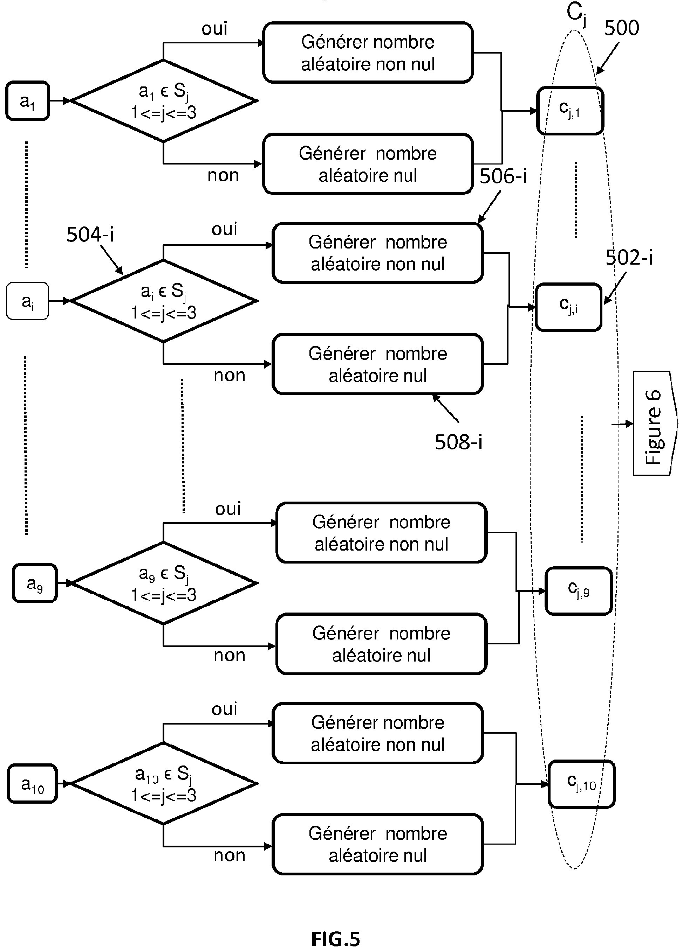

Les figures 4 et 5 détaillent les étapes de génération des vecteurs d'encodage selon les principes de l'invention.

La figure 4 illustre la génération du vecteur d'encodage primaire $C_0$ (400) dans un mode réalisation. Le vecteur d'encodage primaire $C_0$ est composé de 10 coefficients d'encodage primaires $c_{0,1}$ à $c_{0,10}$ où chaque coefficient d'encodage primaire $c_{0,i}$ (402-i) correspond à un nombre aléatoire non nul (404-i).

La figure 5 illustre la génération des vecteurs d'encodage secondaires $C_j$ (1<=j<=3) dans un mode de réalisation (500). Chaque vecteur d'encodage secondaire $C_j$ est composé de 10 coefficients d'encodage secondaires $c_{j,1}$ à $c_{j,10}$.

Pour générer un vecteur $C_j$, le procédé vérifie (504-i) pour chaque bloc $a_i$, si le bloc $a_i$ appartient au sous-ensemble $S_j$. Si c'est le cas (branche oui), le procédé permet d'associer aux coefficients $c_{j,i}$ des nombres aléatoires non nuls (506-i). Si les blocs $a_i$ n'appartiennent pas au sous-ensemble $S_j$ (branche non), le procédé permet d'associer aux coefficients $c_{j,i}$ des nombres aléatoires nuls (508-i).

Par exemple, pour générer le vecteur d'encodage $C_1$, le procédé vérifie, pour chaque bloc de données $a_1$, $a_2$, ..$a_{10}$, s'il appartient au sous-ensemble $S_1$. Comme les blocs de données $a_1$, $a_2$, $a_3$ appartiennent au sous-ensemble $S_1$, le procédé génère donc des nombres aléatoires non nuls pour les coefficients $c_{1,1}$, $c_{1,2}$ et $c_{1,3}$. Comme les blocs de données $a_4$, ..., $a_{10}$ n'appartiennent pas à $S_1$, le procédé génère des nombres aléatoires nuls associés aux coefficients $c_{1,4}$ ... $C_{1,10}$.

Ainsi, pour le sous-ensemble $S_1$, le procédé permet de générer un vecteur d'encodage $C_1$ égal à ($c_{1,1}$, $c_{1,2}$, $c_{1,3}$, 0, 0, 0, 0, 0, 0, 0) où $c_{1,1}$, $c_{1,2}$ et $c_{1,3}$ sont des nombres aléatoires non nuls.

Pour le sous-ensemble $S_2$, le procédé permet de générer un vecteur d'encodage $C_2$ égal à (0, 0, 0, $c_{2,4}$, $c_{2,5}$, $c_{2,6}$, 0, 0, 0, 0) où $c_{2,4}$, $c_{2,5}$ et $c_{2,6}$ sont des nombres aléatoires non nuls.

Pour le sous-ensemble $S_3$, le procédé permet de générer un vecteur d'encodage $C_3$ égal à (0, 0, 0, 0, 0, 0, $c_{3,7}$, $c_{3,8}$, $c_{3,9}$, $c_{3,10}$) où $C_{3,7}$, $C_{3,8}$, $C_{3,9}$ et $C_{3,10}$ sont des nombres aléatoires non nuls.

Revenant à la figure 3, après l'étape de génération des vecteurs d'encodage, le procédé permet de générer (308) 4 fonctions de parité comme des combinaisons linéaires des blocs de données ($a_1$, ..., $a_{10}$) comprenant une fonction de parité primaire $f_0(a)$, et 3 fonctions de parité secondaires $f_1(a)$, $f_2(a)$ et f3(a).

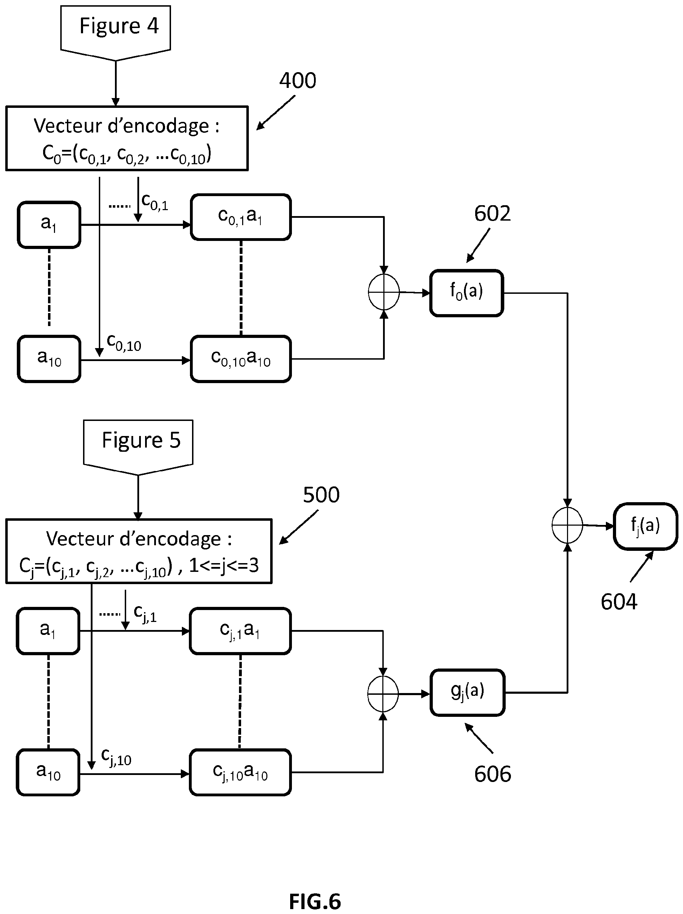

La figure 6 détaille la génération de la fonction de parité primaire $f_0(a)$, et les fonctions de parité secondaires $f_j(a)$ j $\in$ {1, 2, 3} selon les principes de l'invention. La fonction de parité primaire (602) est une combinaison linéaire des 10 blocs de données ($a_1$, ..., $a_{10}$) et est stockée dans le noeud de parité $N_{11}$. A chaque bloc de données $a_i$ est associé le coefficient d'encodage $c_{0,i}$ du vecteur d'encodage primaire $C_0$ (400). La fonction de parité primaire $f_0(a)$ peut s'écrire selon l'équation suivante:

$$- f_0(a) = c_{0,1}{}^* a_1 + c_{0,2}{}^* a_2 + c_{0,3}{}^* a_3 + c_{0,4}{}^* a_4 + c_{0,5}{}^* a_5 + c_{0,6}{}^* a_6 + c_{0,7}{}^* a_7 +$$

$$c_{0,8}{}^* a_8 + c_{0,9}{}^* a_9 + c_{0,10}{}^* a_{10}$$

où les coefficients $c_{0,1}$, $c_{0,2}$, ..., $c_{0,10}$ sont des nombres aléatoires non nuis.

Comme illustré sur la figure 6, pour générer les 3 fonctions de parité secondaires $f_j(a)$ (1<=j<=3) (604), le procédé génère d'abord 3 fonctions linéaires $g_j(a)$ (1<=j<=3) (606). Chaque fonction linéaire $g_j(a)$ est une combinaison linéaire des 10 blocs de données ($a_1$, ..., $a_{10}$) et des vecteurs d'encodage $C_j$ (1<=j<=3) (500).

La fonction linéaire $g_1(a)$ est obtenue par combinaison linéaire des 10 blocs de données ($a_1$, ..., $a_{10}$) et du vecteur d'encodage $C_1$, elle peut alors s'écrire:

$$- g_1(a) = c_{1,1}{}^* a_1 + c_{1,2}{}^* a_2 + c_{1,3}{}^* a_3.$$

La fonction linéaire $g_2(a)$ est obtenue par combinaison linéaire des 10 blocs de données ($a_1$, ..., $a_{10}$) et du vecteur d'encodage $C_2$, elle peut alors s'écrire:

$$- g_2(a) = c_{2,4}{}^* a_4 + c_{2,5}{}^* a_5 + c_{2,6}{}^* a_6.$$

De même, la fonction linéaire $g_3(a)$ est obtenue par combinaison linéaire des 10 blocs de données ($a_1$, ..., $a_{10}$) et du vecteur d'encodage $C_3$, et peut s'écrire:

$$- g_3(a) = c_{3,7}{}^* a_7 + c_{3,8}{}^* a_8 + c_{3,9}{}^* a_9 + c_{3,10}{}^* a_{10}.$$

Une fois les fonctions $g_j(a)$ (1<=j<=3) générées, le procédé permet de créer les fonctions de parité secondaires $f_1(a)$, $f_2(a)$ et $f_3(a)$. La fonction de parité secondaire $f_1(a)$, est obtenue par la somme de la fonction de parité primaire $f_0(a)$ et de la fonction linéaire $g_1(a)$. Elle peut être représentée comme ci-après:

$$- f_1(a) = f_0(a) + g_1(a)$$

De manière similaire, la fonction de parité secondaire $f_2(a)$, est obtenue par la somme de la fonction de parité primaire $f_0(a)$ et de la fonction linéaire $g_2(a)$. Elle peut être représentée comme ci-après:

$$- f_2(a) = f_0(a) + g_2(a)$$

De même, la fonction de parité secondaire $f_3(a)$, est obtenue par la somme de la fonction de parité primaire $f_0(a)$ et de la fonction linéaire $g_3(a)$. Elle peut être représentée comme ci-après:

$$- f_3(a) = f_0(a) + g_3(a)$$

Les fonctions de parité secondaires $f_1(a)$, $f_2(a)$, $f_3(a)$ sont stockées respectivement dans les noeuds de parité $N_{12}$, $N_{13}$ et $N_{14}$ (208).

Avantageusement, les fonctions linéaires $g_1(a)$, $g_2(a)$, $g_3(a)$ et la fonction de parité primaire $f_0(a)$ sont générées de façon à être linéairement indépendantes entre elles. Par ailleurs, la somme de deux de ces fonctions quelconques est également linéairement indépendante des autres fonctions. Enfin, avantageusement, tous les blocs de données étant linéairement indépendants, le code Babylon maintient les mêmes propriétés qu'un code RS.

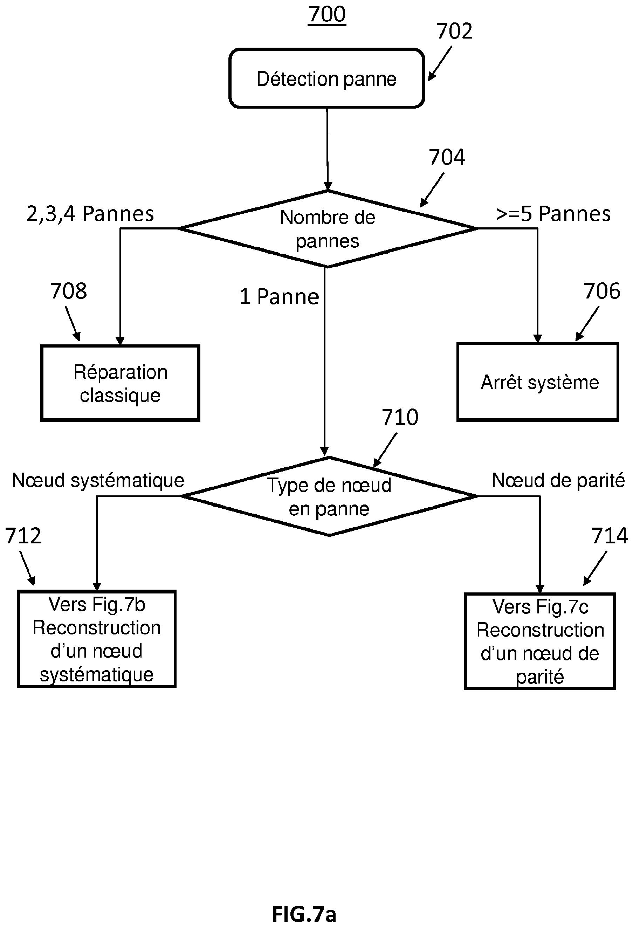

Les figures 7a à 7c illustrent les étapes de détection de pannes et de reconstruction du contenu de noeuds systématiques et de noeuds de parité selon les principes de l'invention.

Comme illustré sur la figure 7a, le procédé est initié (702) quand une information relative à la détection d'une panne dans le système de stockage est disponible indiquant le nombre de pannes (704). Pour les cas où le nombre de pannes est supérieur ou égal à cinq, le procédé de réparation ne peut être opérant et le système est considéré comme défectueux (706). Pour les cas où le nombre de pannes est compris entre deux et quatre pannes, les deux, trois ou quatre noeuds en panne peuvent être reconstruits selon des méthodes de réparation connues (708), de type Erasure Code ou Reed Solomon.

Le procédé revendiqué selon le code Babylon opère pour les cas où un seul noeud de stockage dans un système de stockage local ou distribué est en panne. Les étapes de réparation vont permettre de retrouver dans les autres noeuds de stockage les données perdues qui étaient contenues dans le noeud en panne et de reconstruire un nouveau noeud de stockage avec les mêmes données. Après qu'une panne est détectée, le procédé détermine la nature du noeud qui est en panne (710), à savoir s'il s'agit d'un noeud systématique ou d'un noeud de parité.

Afin de faciliter la compréhension des principes de l'invention et non par limitation, la méthode de reconstruction est d'abord décrite sur un exemple particulier d'un code (k=10, r=4), puis est généralisée pour tout code (k, r).

Description de la méthode de décodage de l'invention sur l'exemple d'un système de stockage avec un code (10, 4) :

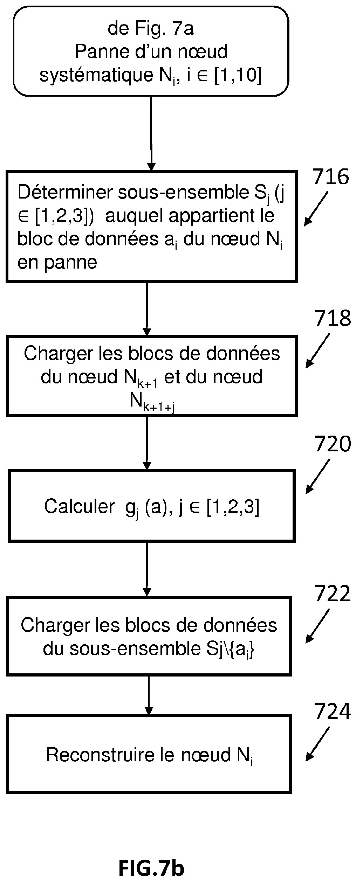

Si la panne concerne un noeud systématique $N_i$, $i \in \{1, .., 10\}$, c'est-à-dire un noeud stockant des blocs de données $a_i$, la reconstruction (712) se fait selon les étapes du procédé décrit en figure 7b.

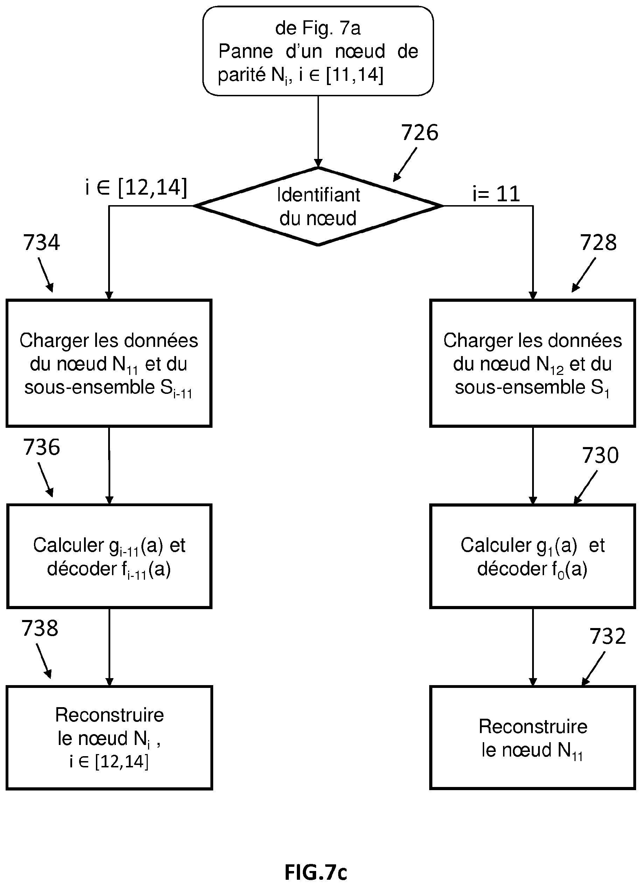

Si la panne concerne un noeud de parité $N_i$, $i \in \{11, .., 14\}$, c'est-à-dire un noeud stockant des fonctions de parité, la reconstruction (714) se fait selon les étapes du procédé décrit en figure 7c.

La figure 7b illustre les étapes de reconstruction d'un noeud systématique selon la présente invention.

Pour illustrer le procédé, il est supposé que le bloc $a_1$ se trouvant dans le noeud $N_1$ est perdu, et qu'il faut le reconstruire. Dans une première étape (716), le procédé permet de déterminer à quel sous-ensemble de données $S_j$, $j \in [1,2,3]$, appartient la donnée $a_i$ du noeud $N_i$ en panne. Dans l'exemple, le bloc de données $a_1$ appartient au sous-ensemble $S_1$, qui contient les données $(a_1, a_2, a_3)$. Dans une étape suivante (718), le procédé permet de récupérer les données de la fonction de parité primaire $f_0(a)$ qui sont stockées dans le noeud $N_{11}$ et de récupérer les données de la fonction de parité secondaire $f_1(a)$ correspondant à l'indice du sous-bloc $S_1$ identifié, qui sont stockées dans le noeud $N_{12}$. L'expression « récupérer les données » est utilisée pour désigner des opérations de transfert des données d'un noeud de stockage vers un dispositif collecteur de données. Le dispositif collecteur de données peut être intégré à un contrôleur du système de stockage général, où peut être mis en oeuvre le procédé de reconstruction de noeuds. La récupération des données inclut également les opérations de lecture/écriture de/dans des éléments de mémorisation des noeuds de stockage et du dispositif collecteur de données.

Après l'étape de collecte de données, le procédé permet (720) à partir des données récupérées, de calculer la fonction linéaire $g_1(a)$ associée au sous-ensemble de données $S_1$ Dans un mode de réalisation, la fonction linéaire $g_j(a)$ est obtenue par soustraction de la fonction de parité primaire $f_0(a)$ se trouvant dans le noeud $N_{11}$ à la fonction de parité secondaire $f_1(a)$ se trouvant dans le noeud $N_{12}$.

Dans une étape suivante (722), le procédé permet de charger les blocs de données (a2, a3) du sous-ensemble $S_1$ à l'exception du bloc $a_1$ qui est perdu. En soustrayant ces données de la fonction linéaire $g_1(a)$, la donnée $a_1$ est retrouvée et le noeud $N_1$ de stockage primaire pour le bloc de données perdu $a_1$ est reconstruit (724).

La reconstruction du noeud pour $a_1$, n'a nécessité l'utilisation que de 4 blocs de données {$a_2$, $a_3$, $f_0(a)$, $f_1(a)$} contrairement à un code RS classique qui aurait nécessité 10 blocs, soit une économie de 60%. De manière similaire, la reconstruction d'un noeud systématique pour tout bloc de données $a_i$ pour $i \in \{1, 2, 3\}$, ne requière que 4 blocs, en utilisant les blocs de données ayant l'index $i \in \{1, 2, 3\}\backslash\{i\}$, c'est-à-dire sauf le bloc de données d'index i correspondant au noeud $N_j$ en panne, et en utilisant les blocs de données des fonctions de parité primaire $f_0(a)$ et de parité secondaire $f_1(a)$.

La reconstruction d'un noeud systématique pour tout bloc de données $a_i$ pour $i \in \{4, 5, 6\}$ requière 4 blocs, en utilisant les blocs de données ayant l'index $i \in \{4, 5, 6\}\backslash\{i\}$ et en utilisant les blocs de données des fonctions de parité primaire $f_0(a)$ et de parité secondaire $f_2(a)$.

La reconstruction d'un noeud systématique pour tout bloc de données $a_i$ pour $i \in \{7, 8, 9, 10\}$ requière 5 blocs, en utilisant les blocs de données ayant l'index $i \in \{7, 8, 9, 10\}\backslash\{i\}$ et en utilisant les blocs de données des fonctions de parité primaire $f_0(a)$ et de parité secondaire $f_3(a)$.

La figure 7c illustre les étapes de reconstruction d'un noeud de parité selon la présente invention.

Les noeuds $N_i$, $i \in [11,14]$ contiennent les fonctions de parité primaire $f_0(a)$ et secondaires $f_1(a)$, $f_2(a)$, $f_3(a)$. Le procédé détermine (726) tout d'abord si le noeud à réparer est le $N_{11}$ qui contient la fonction de parité primaire $f_0(a)$. Si oui, le procédé permet de transférer (728) les données $f_1(a)$ et celles du sous-ensemble $S_1$ contenant $a_1$, $a_2$ et $a_3$ des noeuds $N_{12}$, $N_1$, $N_2$ et $N_3$. Dans une étape suivante (730), le procédé permet de générer la fonction linéaire $g_1(a)$ à l'aide des données $a_1$, $a_2$ et $a_3$, puis de décoder la fonction de parité primaire $f_0(a)$ en soustrayant la fonction linéaire $g_1(a)$ de la fonction de parité $f_1(a)$. Le procédé permet ensuite de reconstruire le noeud $N_{11}$.

De façon similaire que les noeuds i, $i \in \{1, .., 10\}$, la réparation de $N_{11}$ ne nécessite que 4 blocs de données ($f_1(a)$, $a_1$, $a_2$ et $a_3$).

Revenant à l'étape (726), si le noeud à réparer est un nœud_de parité $N_i$ tel que $i \in [12,14]$, le procédé permet de charger (734) les données du noeud $N_{11}$ qui contient la fonction de parité $f_0(a)$, et charger les données des sous-ensembles $S_{i-11}$. Dans une étape suivante (736), le procédé permet de générer la fonction linéaire $g_{i-11}(a)$ à l'aide des données des sous-ensembles $S_{i-11}$ et de décoder la fonction de parité $f_{i-11}(a)$ en effectuant la somme de la fonction de parité primaire $f_0(a)$ et de la fonction linéaire $g_{i-11}(a)$. Le procédé permet ensuite de reconstruire (738) le noeud $N_i$, $i \in [12,14]$.

Ainsi, pour la reconstruction du noeud $N_{12}$ contenant la fonction de parité secondaire $f_1(a)$, le procédé permet de charger la fonction de parité $f_0(a)$ du noeud $N_{11}$ et les données du sous-ensemble $S_1$ ($a_1$ du noeud $N_1$, $a_2$ du noeud $N_2$ et $a_3$ du noeud $N_3$.). Dans un premier temps, la fonction de parité $g_1(a)$ est générée à l'aide des données $a_1$, $a_2$ et $a_3$ du sous-ensemble $S_1$. Ensuite, la fonction de parité secondaire $f_1(a)$ est décodée en effectuant la somme de $f_0(a)$ et $g_1(a)$ et le noeud $N_{12}$ est reconstruit.

De même, pour la reconstruction du noeud $N_{13}$ contenant la fonction de parité secondaire $f_2(a)$, le procédé permet de charger les données du noeud $N_{11}$ qui contient la fonction de parité $f_0(a)$ et les données du sous-ensemble $S_2$. Dans un premier temps, la fonction de parité $g_2(a)$ est générée à l'aide des données $a_4$, $a_5$ et $a_6$ du sous-ensemble $S_2$. Ensuite, la fonction de parité secondaire $f_2(a)$ est décodée en effectuant la somme de $f_0(a)$ et $g_2(a)$ et le noeud $N_{13}$ est reconstruit.

Enfin, pour la reconstruction du noeud $N_{14}$ contenant la fonction de parité secondaire $f_3(a)$, le procédé permet de charger la fonction de parité $f_0(a)$ contenue dans le nœud $N_{11}$ et les données du sous-ensemble $S_3$. Dans un premier temps, la fonction de parité $g_3(a)$ est générée à l'aide des données $a_7$, $a_8$, $a_9$, et $a_{10}$ du sous-ensemble $S_3$. Ensuite, la fonction de parité secondaire $f_3(a)$ est décodée en effectuant la somme de $f_0(a)$ et $g_3(a)$ et le noeud $N_{14}$ est reconstruit.

Il est à noter que la réparation des noeuds $N_{12}$, et $N_{13}$ ne nécessite que le transfert de 4 blocs de données, respectivement {$f_0(a)$, $a_1$, $a_2$ et $a_3$} et {$f_0(a)$, $a_4$, $a_5$ et $a_6$}, et que la réparation du noeud $N_{14}$ nécessite le transfert de 5 blocs de données {$f_0(a)$, $a_7$, $a_8$, $a_9$, $a_{10}$}.

Ainsi avantageusement, le procédé de reconstruction revendiqué ne nécessite que 4 ou 5 blocs de données pour la reconstruction d'un noeud quelconque $i \in \{1, .., 14\}$. Il permet de réduire la bande-passante et les entrées/sorties de 50% à 60% par rapport à un code RS.

Il est maintenant décrit le principe général de la méthode de codage de l'invention pour un code quelconque (k, r) : Partant d'une donnée a en entrée de taille M, le principe général de l'invention consiste à diviser la donnée en k blocs de données ($a_1$, ..., $a_k$), chaque bloc ayant une taille M/k. Chaque bloc de données $a_i$ stocké dans le noeud $N_j$ est de

taille fixe m=M/k.

Les notations suivantes sont convenues pour la suite de la description:

$\lfloor X \rfloor$ exprime la partie entière de X ; et

$\lceil X \rceil$ exprime la partie entière par excès de X.

La méthode de codage Babylon commence par une étape de division des k blocs de données $(a_1, ..., a_k)$ en $(r-1)$ sous-ensembles $(S_1, S_2, .., S_{r-1})$, notés $S_j$, $1 \leq j \leq r -1$. Si k est un multiple de r-1, les sous-ensembles ont une même taille k/r-1. Si k n'est pas un multiple de r-1, chacun des r-1-q premiers sous-ensembles est composé de $t_f$ blocs de données, et les q sous-ensembles suivants contiennent $t_c$ blocs de données avec :

$$t_f = \lfloor k / r\text{-}1 \rfloor,$$

$$t_c = \lceil k / r\text{-}1 \rceil, \quad q = k \bmod (r\text{-}1)$$

Le premier sous-ensemble $S_1$ est composé de blocs de données appartenant à $(a_1, .., a_{tf})$. Le $j^{ème}$ sous-ensemble $S_j$ est composé de blocs de données appartenant à $(a_{(j-1)tf+1}, ..., a_{jtf})$, pour $(1 \leq j \leq r -1)$.

La deuxième étape du procédé consiste à générer r vecteurs d'encodage comprenant un vecteur d'encodage primaire $C_0$ et r-1 vecteurs d'encodage secondaires $C_j$ (1<=j<=r-1).

Le vecteur d'encodage primaire $C_0$ est composé de k coefficients d'encodage $c_{0,1}$ à $c_{0,k}$ où chaque coefficient d'encodage primaire $c_{0,i}$ correspond à un nombre aléatoire non nul.

Un vecteur d'encodage secondaire $C_j$ est composé de k coefficients d'encodage $c_{j,1}$ à $c_{jik}$. Pour générer un vecteur d'encodage secondaire $C_j$, le procédé vérifie, pour chaque bloc $a_i$, si le bloc $a_i$ appartient au sous-ensemble $S_j$. Si c'est le cas, alors le procédé permet d'associer aux coefficients $c_{j,i}$ des nombres aléatoires non nuls, et si le bloc $a_i$ n'appartient pas au sous-ensemble $S_j$ alors le procédé permet d'associer aux coefficients $c_{j,i}$ des nombres aléatoires nuls.

La structure des vecteurs d'encodage $C_0$ à $C_{r-1}$ est représentée ci-après :

$$c_0 = [c_{0,1}, c_{0,2}, .., c_{0,k}]$$

$$c_1 = [c_{1,1}, c_{1,2}, c_{1,tf}, ...., 0, .., 0]$$

$$c_2 = [0, .., 0, c_{2,tf+1}, .., c_{2,2tf}, 0, .., 0]$$

$$\ldots$$

$$c_{r-q} = [0, .., 0, c_{r-q,(r-q-1)tf+1}, ..., c_{r-q,(r-q)tc}, 0, .., 0]$$

$$c_{r-q+1} = [0, .., 0, c_{r-q+1,(r-q)tc+1}, ..., c_{r-q+1,(r-q)tc}, 0, .., 0]$$

$$\ldots$$

$$c_{r-1} = [0, ..., .., 0, c_{r-1,rtc+1}, ..., c_{r-1,k}].$$

Après l'étape de génération des vecteurs d'encodage, le procédé permet de générer r fonctions de parité, combinaisons linéaires des données $(a_1, ..., a_k)$ et composées d'une fonction de parité primaire $f_0(a)$ et de r-1 fonctions de parité secondaires $f_j(a), .., f_{r-1}(a)$.

La fonction de parité primaire est une combinaison linéaire des k blocs de données $(a_1, ..., a_k)$ et est stockée dans le noeud de parité d'index k+1, $N_{k+1}$. A chaque bloc de données $a_i$ est associé le coefficient d'encodage $c_{0,i}$ du vecteur d'encodage primaire $C_0$. La fonction de parité primaire $f_0(a)$ peut s'écrire selon l'équation suivante:

$$- f_0(a) = c_{0,1}{}^* a_1 + c_{0,2}{}^* a_2 + ...... + c_{0,k}{}^* a_k$$

où les coefficients $c_{0,1}, c_{0,2}, ..., c_{0,k}$ sont des nombres aléatoires non nuis.

Pour générer les r-1 fonctions de parité secondaires $f_j(a)$ (1<=j<=r-1), le procédé permet de générer d'abord r-1 fonctions linéaires $g_j(a)$ (1<=j<=r-1). Chaque fonction linéaire $g_j(a)$ est une combinaison linéaire des k blocs de données $(a_1, ..., a_k)$ et des vecteurs d'encodage $C_j$ (1<=j<=r-1). Une fois les fonctions linéaires $g_j(a)$ (1<=j<=r-1) générées, le procédé permet de créer les fonctions de parité secondaires $f_1(a)$, $f_2(a)$, ... $f_{r-1}(a)$ tel qu'une fonction de parité secondaire $f_j(a)$, $1 \le j \le r - 1$, est obtenue en additionnant la fonction de parité primaire $f_0(a)$ à une fonction linéaire $g_j(a)$ :

$$- \quad f_j(a) = f_0(a) + g_j(a).$$

Les blocs de données et les fonctions de parité générées selon le codage de l'invention sont stockés dans des noeuds de stockage d'un système de stockage local ou distribué. Les k blocs de données $(a_1, ..., a_k)$ sont stockés dans k noeuds systématiques $N_i$, $i \in \{1, .., k\}$, et chacun des r blocs de parité obtenu par une fonction de parité est stocké dans un noeud de parité $N_i$, $i \in \{k+1, .., k+r\}$, comme illustré sur la table ci-dessous :

| Node 1 | $a_1$ |
|---|---|
| . | . |
| . | . |
| Node k | $a_k$ |
| Node k+1 | $f_0(a)$ |
| Node k+2 | $f_0(a) + g_1(a)$ |
| . | . |
| . | . |
| Node k+r | $f_0(a) + g_{r-1}(a)$ |

Avantageusement, les fonctions linéaires $g_j(a)$, $1 \le j \le r-1$ et la fonction de parité primaire $f_0(a)$ sont générées de façon à être linéairement indépendantes entre elles. Par ailleurs, la somme de deux de ces fonctions quelconques est également linéairement indépendante des autres fonctions. Enfin, avantageusement, tous les blocs de données étant linéairement indépendants, le code Babylon maintient les mêmes propriétés qu'un code RS.

Il est maintenant décrit le principe général de la méthode de reconstruction de l'invention pour un code quelconque (k, r). Le procédé de reconstruction est initié quand une information relative à la détection d'une panne dans le système de stockage est disponible. Le procédé peut être initié pour dupliquer le contenu d'un noeud. Le procédé de reconstruction en cas de panne opère pour les cas où un seul noeud de stockage dans un système de stockage local ou distribué est en panne. Les étapes de réparation vont permettre de retrouver dans les autres noeuds de stockage les données perdues qui étaient contenues dans le noeud en panne et de reconstruire un nouveau noeud de stockage avec les mêmes données.

Lorsqu'une panne est détectée, le procédé détermine la nature du noeud qui est en panne, à savoir s'il s'agit d'un noeud systématique ou d'un noeud de parité systématique.

Si la panne concerne un noeud systématique $N_i$, $i \in \{1, .., k\}$, c'est-à-dire un noeud stockant des blocs de données $a_i$, la reconstruction se fait selon le cas 1 décrit ci-après.

Si la panne concerne un noeud de parité $N_i$, $i \in \{k+1, .., k+r\}$, c'est-à-dire un noeud stockant des fonctions de parité, la reconstruction se fait selon le cas 2 décrit ci-après.

- Cas 1 : Reconstruction des noeuds $N_i$, $i \in \{1, .., k\}$

En considérant une réparation de la donnée $a_i$ stockée dans un noeud $N_i$ tel que $(1 \le i \le k)$ avec $a_i \in S_j$ et $(1 \le j < r)$, le procédé permet initialement de transférer les données contenues dans les noeuds d'index k+1, $N_{(k+1)}$ et d'index k+1+j, $N_{(k+1+j)}$. Ensuite, la donnée $f_0(a)$, stockée dans le noeud d'index k+1, $N_{(k+1)}$, est soustraite de la donnée $f_j(a)$ stockée dans le noeud d'index k+1+j, $N_{(k+1+j)}$ pour récupérer la fonction linéaire $g_j(a)$ associée au sous-ensemble $S_j$. Le procédé permet ensuite de transférer les données du sous-ensemble $S_j\backslash\{a_i\}$ (c'est-à-dire à l'exception du bloc de données $a_i$). L'utilisation de la fonction linéaire $g_j(a)$ permet de décoder la donnée perdue $a_i$. Le nombre de blocs de données nécessaires pour reconstruire $a_i$ est donc $(t_f + 1)$ si i appartient aux (r-1-q) premiers sous-blocs. Si i appartient aux q derniers sous-blocs, le nombre total de blocs de données requis est $(t_c + 1)$.

- Cas 2 : Reconstruction des noeuds $N_i$, $i \in \{k+1, .., k+r\}$

Comme dans le cas précédent, pour la reconstruction du noeud $N_i$ tel que $k + 1 < i \le k + r$, le procédé permet de transférer la donnée $f_0(a)$ stockée dans le noeud d'index $k+1$, $N_{(k+1)}$, et les données se trouvant dans le sous-ensemble $S_{i-k+1}$. La fonction linéaire $g_{i-k+1}(a)$ est obtenue à partir des données du sous ensemble $S_{i-k+1}$. Ensuite, le décodage est réalisé en utilisant la fonction primaire $f_0(a)$ et la fonction linéaire $g_{i-k+1}(a)$ pour retrouver la fonction secondaire $f_{i-k+1}(a)$ (en effet, $f_{i-k+1}(a) = f_0(a) + g_{i-k+i}(a)$). Il est à noter que si $(i - k + 1)$ appartient aux $(r-1-q)$ premiers blocs, la réparation requière $(t_f+1)$ blocs de données. Si $(i-k+1) \in \{r-q,..,r-1\}$, alors la réparation nécessite $(t_c +1)$ blocs.
Pour le cas particulier du noeud d'index $k+1$, $N_{k+1}$ contenant la fonction de parité primaire $f_0(a)$, le procédé permet de transférer le premier sous-ensemble $S_1$ pour générer la fonction linéaire $g_1(a)$. Le procédé permet ensuite de transférer les données du noeud d'index $k+2$, $N_{k+2}$ contenant la fonction de parité secondaire $f_1(a)$. En soustrayant la fonction linéaire $g_1(a)$ de la fonction de parité secondaire $f_1(a)$, la fonction de parité primaire $f_0(a)$ est décodée (en effet, $f_0(a) = f_1(a) - g_1(a)$). La donnée du noeud d'index $k+1$, $N_{k+1}$ contenant la fonction de parité primaire $f_0(a)$ est retrouvée en utilisant $(t_f + 1)$ blocs de données.
De manière générale, la valeur moyenne des données transférées et lues pour la reconstruction/réparation, quelque soit le type de noeud, est donnée par l'équation suivante :

$$\gamma = \frac{1}{(k+r)}\left[(((r - 1 - q) \times t_f + (r - q)) \times (t_f + 1)) + (q(t_c + 1)^2)\right]$$

Il est à noter que la description prend exemple pour une valeur de r >=3. Pour une valeur r=1, le code Babylon agit comme un code RS classique. Pour une valeur r=2, les données sont divisées en deux sous-ensembles $S_1$ et $S_2$, où $S_1$ est composé des $t_s$ premiers blocs et $S_2$ contient les $k-t_s$ derniers blocs, où $t_s = \lfloor k / r \rfloor$.
Avantageusement, le procédé de l'invention permet de ne pas utiliser tous les noeuds dans le processus de reconstruction. Par ailleurs, les noeuds contribuant à la reconstruction n'ont pas à effectuer de calculs, mais ils n'ont juste qu'à transférer leur contenu vers un collecteur de données où vont s'effectuer les opérations de décodage. Le collecteur de données peut être le nouveau noeud de stockage de remplacement du noeud en panne.
Toujours avantageusement, grâce au procédé de codage Babylon, le temps de reconstruction est diminué par rapport à des méthodes à base de matrices où l'ensemble des blocs de données des k noeuds est nécessaire à la reconstruction.

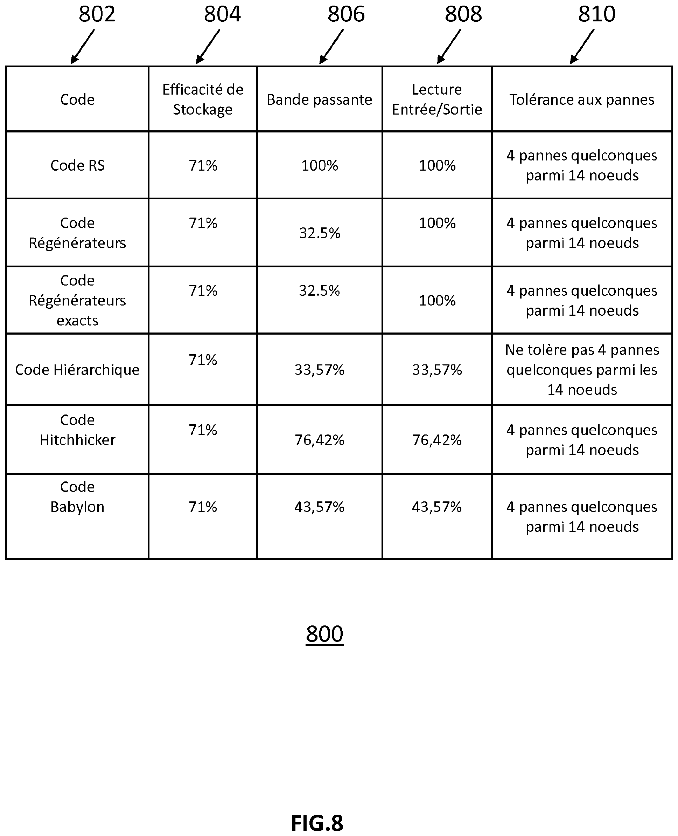

La figure 8 est un tableau comparatif des performances comparant les résultats de différents codes connus avec ceux obtenus par le code Babylon de la présente invention. Dans la table (800), la première colonne liste les codes comparés : RS ; Régénérateurs ; Régénérateurs exacts ; Hiérarchique ; Hitchhicker ; et Babylon.
Il a été considéré pour tous les codes un fichier de même taille de M octets codés en utilisant une configuration (k=10, r=4).
L'évaluation a été faite pour chaque code pour une même efficacité de stockage (71%) colonne (804) sur différents paramètres : la bande passante moyenne requise pour la réparation (806), les entrées/ sorties disques (808) et la tolérance aux pannes 810). La bande passante et les entrées /sorties disques sont exprimées en pourcentage par rapport à la taille M du fichier original. Les pourcentages dans le tableau sont calculés en tenant en compte de la réparation des noeuds systématiques et des noeuds de parité.
Les résultats sont les suivants :

- Pour un code RS, la réparation d'une seule panne nécessite la lecture et le transfert de M octets. Ceci est équivalent à 100% de la taille originale du fichier.
- Pour la même efficacité de stockage, on calcule la bande passante requise par les codes régénérateurs et les codes régénérateurs exacts. La bande passante utilisée pour la réparation d'une panne est en moyenne égale à 32.5%. Cependant, les entrées/ sorties disques ne sont pas optimisées. Pour réparer une seule panne les codes régénérateurs nécessitent la lecture de toutes les données stockées dans les noeuds avant de les transférer.
- Le code Hiérarchique optimise à la fois la bande passante et les entrées/sorties disques. La quantité des données lues et transférées dans le réseau est égale 33,57%. Cependant, le code Hiérarchique ne maintient pas la même tolérance aux pannes que les codes RS. En effet, on ne peut tolérer 4 pannes quelconques en utilisant le code Hiérarchique.
- Le code Hitchhicker permet à la fois d'optimiser la bande passante et les entrées/sorties disques en maintenant la même tolérance aux pannes que le code RS. Dans ce cas, la quantité des données lues et transférées est égale à 76,42%.

- Le code Babylon nécessite en moyenne 43.57% de la taille du fichier original pour réparer une seule panne en termes de bande passante et d'entrées/sorties disques. Il permet aussi de tolérer 4 pannes quelconques parmi les 14 noeuds.

La présente invention peut s'implémenter à partir d'éléments matériel et/ou logiciel. Elle peut être disponible en tant que produit programme d'ordinateur sur un support lisible par ordinateur. Le support peut être électronique, magnétique, optique ou électromagnétique. Dans un mode de réalisation, la méthode est mise en oeuvre par ordinateur. Il est décrit un produit programme d'ordinateur, ledit programme d'ordinateur comprenant des instructions de code permettant d'effectuer une ou plusieurs des étapes de la méthode, lorsque ledit programme est exécuté sur un ordinateur. Dans un mode de réalisation, le dispositif pour la mise en oeuvre de l'invention comprend un support de stockage lisible par ordinateur (RAM, ROM, mémoire flash ou une autre technologie de mémoire, par exemple support à disque ou un autre support de stockage non transitoire lisible par ordinateur) codé avec un programme d'ordinateur (c'est-à-dire plusieurs instructions exécutables) qui, lorsqu'il est exécuté sur un ou plusieurs processeurs, effectue les fonctions des modes de réalisation décrits précédemment. A titre d'exemple d'architecture matérielle adaptée à mettre en oeuvre l'invention, un dispositif peut comporter un bus de communication auquel sont reliés une unité centrale de traitement ou microprocesseur (CPU, acronyme de « Central Processing Unit » en anglais), lequel processeur peut être "multi-core" ou "many-core"; une mémoire morte (ROM, acronyme de « Read Only Memory » en anglais) pouvant comporter les programmes nécessaires à la mise en oeuvre de l'invention; une mémoire vive ou mémoire cache (RAM, acronyme de « Random Access Memory » en anglais) comportant des registres adaptés à enregistrer des variables et paramètres créés et modifiés au cours de l'exécution des programmes précités ; et une interface de communication ou E/S (I/O acronyme de « Input/ouput » en anglais) adaptée à transmettre et à recevoir des données. Dans le cas où l'invention est implantée sur une machine de calcul reprogrammable (par exemple un circuit FPGA), le programme correspondant (c'est-à-dire la séquence d'instructions) peut être stocké dans ou sur un médium de stockage amovible (par exemple une carte SD, ou un stockage de masse tel qu'un disque dur e.g. un SSD) ou non-amovible, volatile ou non-volatile, ce médium de stockage étant lisible partiellement ou totalement par un ordinateur ou un processeur. Le support lisible par ordinateur peut être transportable ou communicable ou mobile ou transmissible (i.e. par un réseau de télécommunication 2G, 3G, 4G, Wifi, BLE, fibre optique ou autre). La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur, comme des web services ou SOA ou via des interfaces de programmation API) qui peut être utilisé pour programmer un ou plusieurs processeurs pour mettre en oeuvre des aspects des techniques décrites ici. Les moyens ou ressources informatiques peuvent notamment être distribués ("Cloud computing"), éventuellement avec ou selon des technologies de pair-à-pair et/ou de virtualisation. Le code logiciel peut être exécuté sur n'importe quel processeur approprié (par exemple, un microprocesseur) ou coeur de processeur ou un ensemble de processeurs, qu'ils soient prévus dans un dispositif de calcul unique ou répartis entre plusieurs dispositifs de calcul (éventuellement accessibles dans l'environnement du dispositif). Des technologies de sécurisation (crypto-processeurs, authentification, chiffrement, carte à puce, etc) peuvent être utilisées.

**Revendications**

1. Méthode de codage (k, r) de données comprenant des étapes consistant à:

   - diviser (302) une donnée initiale a en k blocs de données $a_i$ de même taille;
   - grouper (304) les k blocs de données en r-1 sous-ensembles disjoints $S_j$ de blocs données ;
   - générer (606) pour chaque sous-ensemble $S_j$ une fonction linéaire $g_j(a)$ définie comme une combinaison linéaire des blocs de données assignés audit sous-bloc $S_j$ ; et
   - générer (604) r fonctions de parité comprenant une fonction de parité primaire $f_0(a)$ comme une combinaison linéaire des k blocs de données $a_i$, et r-1 fonctions de parité secondaires, chaque fonction de parité secondaire $f_j(a)$ étant définie comme la somme de la fonction de parité primaire $f_0(a)$ et d'une fonction linéaire $g_j(a)$, l'étape de générer (308) r fonctions de parité consistant à générer (306) r vecteurs d'encodage comprenant :

      - un vecteur d'encodage primaire $C_0$ composé de k coefficients d'encodage primaires $c_{0,1}$ à $c_{0,k}$ où chaque coefficient d'encodage primaire $c_{0,i}$ correspond à un nombre aléatoire non nul ; et
      - r-1 vecteurs d'encodage secondaires $C_j$ (1<=j<=r-1), chaque vecteur d'encodage secondaire étant composé de k coefficients d'encodage secondaires $c_{j,1}$ à $c_{j,k}$ où un coefficient d'encodage secondaire $c_{j,i}$ correspond à un nombre aléatoire non nul ou nul selon que le bloc de données $a_i$ appartient ou n'appartient pas au sous-ensemble $S_j$.

2. La méthode selon la revendication 1 dans laquelle l'étape de générer une fonction linéaire $g_j(a)$ consiste à générer une combinaison linéaire à partir des k blocs de données $(a_1, ..., a_k)$ et des k coefficients d'encodage secondaires $c_{j,1}$ à $c_{j,k}$ du vecteur d'encodage secondaire $C_j$.

3. La méthode selon la revendication 1 ou 2 dans laquelle k=10 et r=4.

4. Méthode de stockage de k+r données comprenant au moins une étape consistant à stocker (204) dans k équipements de stockage systématique $N_i$, $i \in \{1, .., k\}$, k blocs de données $a_i$, et à stocker dans r équipements de stockage de parité $N_i$, $i \in \{k+1, .., k+r\}$, r fonctions de parité, les r fonctions de parité étant obtenues selon la méthode de codage de données de l'une quelconque des revendications 1 à 3.

5. Dispositif de codage de données comprenant des moyens adaptés pour mettre en oeuvre les étapes de la méthode de codage de données selon l'une quelconque des revendications 1 à 3.

6. Méthode de reconstruction du contenu d'un équipement de stockage parmi une pluralité d'équipements stockant k blocs de données $a_i$ dans k équipements de stockage systématique $N_i$, $i \in \{1, .., k\}$, et r fonctions de parité $f_j(a)$ dans r équipements de stockage de parité $N_i$, $i \in \{k+1, .., k+r\}$, les dits k blocs de données et r fonctions de parité étant obtenus selon la méthode de l'une quelconque des revendications 1 à 3, la méthode de reconstruction comprenant au moins des étapes consistant à:

   - déterminer (700) si l'équipement de stockage pour lequel reconstruire le contenu est un équipement de stockage systématique ou de parité;
   - si ledit équipement est un équipement de stockage systématique $N_i$, $i \in \{1, .., k\}$ :

      - déterminer (716) à quel sous-ensemble de données $S_j$, le bloc de données dudit équipement appartient ;
      - récupérer (718) les fonctions de parité primaire et secondaire stockées dans les équipements de stockage de parité k+1 et k+1+j ;
      - calculer (720) la fonction linéaire $g_j(a)$ associée au sous-ensemble $S_j$ ;
      - récupérer (722) les blocs de données du sous-ensemble $S_j$ à l'exception du bloc $a_i$ ; et
      - reconstruire (724) le contenu dudit équipement de stockage systématique $N_i$, $i \in \{1, .., k\}$ ;

   - si ledit équipement est un équipement de stockage de parité $N_i$, $i \in \{k+1, .., k+r\}$, déterminer (726) l'index i identifiant ledit équipement de stockage ;

      - si l'index i est égal à k+1 :

         ▪ récupérer (728) la fonction de parité secondaire $f_1(a)$ stockée dans l'équipement de stockage de parité d'index i=k+2 et les blocs de données $a_i$ du sous-ensemble $S_1$ ;
         ▪ calculer (730) la fonction linéaire $g_1(a)$ associée au sous-ensemble $S_1$ et décoder la fonction de parité primaire $f_0(a)$ ; et
         ▪ reconstruire (732) le contenu dudit équipement de parité d'index i=k+1 ;

      - si l'index i est supérieur à k+1 :

         ▪ Récupérer (734) la fonction de parité primaire $f_0(a)$ stockée dans l'équipement de stockage de parité d'index i=k+1 et les blocs de données $a_i$ du sous-ensemble $S_{i-k+1}$ ;
         ▪ calculer (736) la fonction linéaire $g_{i-k+1}(a)$ associée au sous-ensemble $S_{i-k+1}$ et décoder la fonction de parité secondaire $f_{i-k+1}(a)$ ; et
         ▪ reconstruire (738) le contenu dudit équipement de parité d'index i>k+1.

7. La méthode selon la revendication 6 dans laquelle les étapes de récupérer les fonctions de parité consistent à transférer les données des équipements de stockage correspondants vers un équipement collecteur de données.

8. La méthode selon la revendication 6 ou 7 dans laquelle l'étape de calculer la fonction linéaire $g_j(a)$ associée au sous-ensemble $S_j$ pour la reconstruction d'un noeud systématique i tel que $i \in \{1, .., k\}$, consiste à soustraire la fonction de parité primaire stockée dans l'équipement de stockage $N_{k+1}$ de la fonction de parité secondaire stockée dans l'équipement de stockage $N_{k+1+j}$.

9. La méthode selon l'une quelconque des revendications 6 à 8 dans laquelle l'étape de calculer la fonction linéaire $g_1(a)$ associée au sous-ensemble $S_1$ pour la reconstruction d'un noeud de parité i tel que i=k+1, consiste à générer une combinaison linéaire à partir des blocs de données du sous-ensemble $S_1$ et du vecteur d'encodage $C_1$, et l'étape de calculer la fonction linéaire $g_j(a)$ associée au sous-ensemble $S_j$ pour la reconstruction d'un noeud de parité i tel que ie {k+2, .., k+r}, consiste à générer une combinaison linéaire à partir des blocs de données du sous-ensemble $S_j$ et du vecteur d'encodage $C_j$.

10. La méthode selon l'une quelconque des revendications 6 à 9 dans laquelle l'étape de reconstruire le contenu dudit équipement de stockage systématique consiste à décoder le bloc de données $a_i$ à partir de la fonction linéaire $g_j(a)$.

11. La méthode selon l'une quelconque des revendications 6 à 9 dans laquelle l'étape de reconstruire le contenu dudit équipement de stockage de parité i tel que i=k+1 consiste à décoder la fonction de parité secondaire dudit équipement de parité d'index i=k+1 à partir de la fonction linéaire $g_1(a)$ calculée, et l'étape de reconstruire le contenu dudit équipement de stockage de parité i tel que i>k+1 consiste à décoder la fonction de parité secondaire dudit équipement de parité d'index i>k+1 à partir de la fonction linéaire $g_{i-k+1}(a)$ calculée.

12. Dispositif de reconstruction du contenu d'un équipement de stockage parmi une pluralité d'équipements stockant k blocs de données $a_i$ dans k équipements de stockage systématique $N_i$, i∈ {1, .., k}, et r fonctions de parité $f_j(a)$ dans r équipements de stockage de parité $N_i$, i ∈ {k+1, .., k+r}, les dits k blocs de données et r fonctions de parité étant obtenus selon la méthode de l'une quelconque des revendications 1 à 3, le dispositif comprenant des moyens adaptés pour mettre en oeuvre les étapes de la méthode de reconstruction du contenu d'un équipement de stockage selon l'une quelconque des revendications 6 à 11.

13. Produit programme d'ordinateur comprenant un programme, ledit programme comprenant des instructions de code permettant d'effectuer les étapes de la méthode selon l'une quelconque des revendications 1 à 3 et/ou comprenant des instructions de code permettant d'effectuer les étapes de la méthode selon l'une quelconque des revendications 6 à 11, lorsque ledit programme est exécuté sur un ordinateur.

14. Circuit intégré de type ASIC ou FPGA comprenant au moins un dispositif selon la revendication 5 et/ou selon la revendication 12.

15. Utilisation de la méthode de reconstruction de contenu selon l'une quelconque des revendications 6 à 11 dans un système de stockage distribué, ledit système de stockage distribué comprenant une pluralité de noeuds de stockage de données aptes à stocker des données codées selon la méthode de codage de l'une quelconque des revendications 1 à 3.

16. Utilisation de la méthode de reconstruction de contenu selon l'une quelconque des revendications 6 à 11 dans un système de stockage local, ledit système de stockage local comprenant des disques de stockage de données aptes à stocker des données codées selon la méthode de codage de l'une quelconque des revendications 1 à 3.

**Patentansprüche**

1. Verfahren zum Codieren (k, r) von Daten, umfassend Schritte bestehend aus Folgendem:

   - Teilen (302) eines Anfangsdatums in k Datenblöcke $a_i$ von gleicher Größe;
   - Gruppieren (304) der k Datenblöcke in r-1 unzusammenhängende Teilmengen $S_j$ von Datenblöcken;
   - Erzeugen (606), für jede Teilmenge $S_j$, einer linearen Funktion $g_j(a)$, die als eine lineare Kombination aus den dem Teilblock $S_j$ zugeordneten Datenblöcken definiert ist; und
   - Erzeugen (604) von r Paritätsfunktionen, umfassend eine primäre Paritätsfunktion $f_0(a)$, als eine lineare Kombination der k Datenblöcke $a_i$, und r-1 sekundäre Paritätsfunktionen, wobei jede sekundäre Paritätsfunktion $f_j(a)$ als die Summe der primären Paritätsfunktion $f_0(a)$ und einer linearen Funktion $g_j(a)$ definiert ist, wobei der Schritt des Erzeugens (308) von r Paritätsfunktionen darin besteht, r Codierungsvektoren zu erzeugen (306), die Folgendes umfassen:

      - einen primären Codierungsvektor $C_0$, der aus k primären Codierungskoeffizienten $c_{0,1}$ bis $c_{0,k}$ zusammengesetzt ist, worin jeder primäre Codierungskoeffizient $c_{0,i}$ einer zufälligen Zahl ungleich Null entspricht; und

- r-1 sekundäre Codierungsvektoren $C_j$ (1<=j<=r-1), wobei jeder sekundäre Codierungsvektor aus k sekundären Codierungskoeffizienten $c_{j,1}$ bis $c_{j,k}$ zusammengesetzt ist, worin ein sekundärer Codierungskoeffizient $c_{j,i}$ einer zufälligen Zahl ungleich Null oder gleich Null abhängig davon entspricht, ob der Datenblock $a_i$ zu der Teilmenge $S_j$ gehört oder nicht.

2. Verfahren nach Anspruch 1, wobei der Schritt des Erzeugens einer linearen Funktion $g_j(a)$ darin besteht, eine lineare Kombination aus den k Datenblöcken ($a_1$ ..., $a_k$) und den k sekundären Codierungskoeffizienten $c_{j,1}$ bis $c_{j,k}$ des sekundären Codierungssektors $C_j$ zu erzeugen.

3. Verfahren nach Anspruch 1 oder 2, wobei k=10 und r=4.

4. Speicherverfahren für k+r Daten, umfassend mindestens einen Schritt bestehend aus dem Speichern (204), in k systematischen Speichereinrichtungen $N_i$, i E {1, .., k}, von k Datenblöcken $a_i$, und aus dem Speichern, in r Paritätsspeichereinrichtungen $N_i$, i E {k+1, .., k+r}, von r Paritätsfunktionen, wobei die r Paritätsfunktionen nach dem Datencodierungsverfahren nach einem der Ansprüche 1 bis 3 erhalten werden.

5. Vorrichtung zum Codieren von Daten, umfassend Mittel, die dafür geeignet sind, die Schritte des Datencodierungsverfahrens nach einem der Ansprüche 1 bis 3 zu implementieren.

6. Verfahren zur Rekonstruktion des Inhalts einer Speichereinrichtung aus einer Vielzahl von Einrichtungen, die k Datenblöcke $a_i$ in k systematischen Speichereinrichtungen $N_i$, i ∈ {1, .., k}, und r Paritätsfunktionen $f_j(a)$ in r Paritätsspeichereinrichtungen $N_i$, i E {k+1, .., k+r} speichern, wobei die k Datenblöcke und r Paritätsfunktionen nach dem Verfahren nach einem der Ansprüche 1 bis 3 erhalten werden, wobei das Rekonstruktionsverfahren mindestens Schritte umfasst, die aus Folgendem bestehen:

- Bestimmen (700), ob die Speichereinrichtung, für die der Inhalt zu rekonstruieren ist, eine systematische Speichereinrichtung oder eine Paritätsspeichereinrichtung ist;
- falls die Einrichtung eine systematische Speichereinrichtung $N_i$, i ∈ {1, .., k} ist:

  - Bestimmen (716), zu welcher Datenteilmenge $S_j$ der Datenblock der Einrichtung gehört;
  - Wiederherstellen (718) der primären und sekundären Paritätsfunktionen, die in den Paritätsspeichereinrichtungen k+1 und k+1+j gespeichert sind;
  - Berechnen (720) der linearen Funktion $g_j(a)$, die der Teilmenge $S_j$ zugeordnet ist;
  - Wiederherstellen (722) der Datenblöcke der Teilmenge $S_j$, außer für den Block $a_i$; und
  - Rekonstruieren (724) des Inhalts der systematischen Speichereinrichtung $N_i$, i E {1, .., k};
  - falls die Einrichtung eine Paritätsspeichereinrichtung $N_i$, i E {k+1, .., k+r} ist, Bestimmen (726) des Indexes i, der die Speichereinrichtung identifiziert;
  - falls der Index i gleich k+1 ist:

    - Wiederherstellen (728) der sekundären Paritätsfunktion $f_1(a)$, die in der Paritätsspeichereinrichtung des Indexes i=k+2 gespeichert ist, und der Datenblöcke $a_i$ der Teilmenge $S_1$;
    - Berechnen (730) der linearen Funktion $g_1(a)$, die der Teilmenge $S_1$ zugeordnet ist, und Decodieren der primären Paritätsfunktion $f_0(a)$; und
    - Rekonstruieren (732) des Inhalts der Paritätseinrichtung des Indexes i=k+1;

    - falls der Index i größer als k+1 ist:

    - Wiederherstellen (734) der primären Paritätsfunktion $f_0(a)$, die in der Paritätsspeichereinrichtung des Indexes i=k+1 gespeichert ist, und der Datenblöcke $a_i$ der Teilmenge $S_{i-k+1}$;
    - Berechnen (736) der linearen Funktion $g_{i-k+1}(a)$, die der Teilmenge $S_{i-k+1}$ zugeordnet ist, und Decodieren der sekundären Paritätsfunktion $f_{i-k+1}(a)$; und
    - Rekonstruieren (738) des Inhalts der Paritätseinrichtung des Indexes i>k+1.

7. Verfahren nach Anspruch 6, wobei die Schritte des Wiederherstellens der Paritätsfunktionen darin bestehen, die Daten der entsprechenden Speichereinrichtungen an eine Datenerfassungseinrichtung zu übertragen.

8. Verfahren nach Anspruch 6 oder 7, wobei der Schritt des Berechnens der linearen Funktion $g_j(a)$, die der Teilgruppe $S_j$ zugeordnet ist, zur Rekonstruktion eines systematischen Knotens i, sodass i E {1, .., k}, darin besteht, die in der Speichereinrichtung $N_{k+1}$ gespeicherte primäre Paritätsfunktion von der in der Speichereinrichtung $N_{k+1+j}$ gespeicherten sekundären Paritätsfunktion abzuziehen.

9. Verfahren nach einem der Ansprüche 6 bis 8, wobei der Schritt des Berechnens der linearen Funktion $g_1(a)$, die der Teilmenge $S_1$ zugeordnet ist, zur Rekonstruktion eines Paritätsknotens i, sodass i=k+1, darin besteht, eine lineare Kombination aus den Datenblöcken der Teilmenge $S_1$ und dem Codierungsvektor $C_1$ zu erzeugen, und wobei der Schritt des Berechnens der linearen Funktion $g_j(a)$, die der Teilmenge $S_j$ zugeordnet ist, zur Rekonstruktion eines Paritätsknotens i, sodass i E {k+2, .., k+r}, darin besteht, eine lineare Kombination aus den Datenblöcken der Teilmenge $S_j$ und dem Codierungsvektor $C_j$ zu erzeugen.

10. Verfahren nach einem der Ansprüche 6 bis 9, wobei der Schritt des Rekonstruierens des Inhalts der systematischen Speichereinrichtung darin besteht, den Datenblock $a_i$ anhand der linearen Funktion $g_j(a)$ zu decodieren.

11. Verfahren nach einem der Ansprüche 6 bis 9, wobei der Schritt des Rekonstruierens des Inhalts der Paritätsspeichereinrichtung i, sodass i=k+1, darin besteht, die sekundäre Paritätsfunktion der Paritseinrichtung des Indexes i=k+1 anhand der berechneten linearen Funktion $g_1(a)$ zu decodieren, und der Schritt des Rekonstruierens des Inhalts der Paritätsspeichereinrichtung i, sodass i>k+1, darin besteht, die sekundäre Paritätsfunktion der Paritätseinrichtung des Indexes i>k+1 anhand der berechneten linearen Funktion $g_{i-k+1}(a)$ zu decodieren.

12. Vorrichtung zum Rekonstruieren des Inhalts einer Speichereinrichtung aus einer Vielzahl von Einrichtungen, die k Datenblöcke $a_i$ in k systematischen Speichereinrichtungen $N_i$, i ∈ {1, .., k}, und r Paritätsfunktionen $f_j(a)$ in r Paritätsspeichereinrichtungen $N_i$, i E {k+1, .., k+r } speichern, wobei die k Datenblöcke und r Paritätsfunktionen nach dem Verfahren nach einem der Ansprüche 1 bis 3 erhalten werden, wobei die Vorrichtung Mittel umfasst, die dafür geeignet sind, die Schritte des Verfahrens zum Rekonstruieren des Inhalts einer Speichereinrichtung nach einem der Ansprüche 6 bis 11 zu implementieren.

13. Computerprogrammprodukt, umfassend ein Programm, wobei das Programm Codebefehle umfasst, die das Durchführen der Schritte des Verfahrens nach einem der Ansprüche 1 bis 3 ermöglichen, und/oder Codebefehle umfasst, die das Durchführen der Schritte des Verfahrens nach einem der Ansprüche 6 bis 11 ermöglichen, wenn das Programm auf einem Computer ausgeführt wird.

14. Integrierte Schaltung vom ASIC- oder FPGA-Typ, umfassend mindestens eine Vorrichtung nach Anspruch 5 und/oder nach Anspruch 12.

15. Verwendung des Verfahrens zum Rekonstruieren von Inhalt nach einem der Ansprüche 6 bis 11 in einem verteilten Speichersystem, wobei das verteilte Speichersystem eine Vielzahl von Datenspeicherknoten umfasst, die dafür geeignet sind, nach dem Codierungsverfahren nach einem der Ansprüche 1 bis 3 codierte Daten zu speichern.

16. Verwendung des Verfahrens zum Rekonstruieren von Inhalt nach einem der Ansprüche 6 bis 11 in einem lokalen Speichersystem, wobei das lokale Speichersystem Datenspeicherplatten umfasst, die dafür geeignet sind, nach dem Codierungsverfahren nach einem der Ansprüche 1 bis 3 codierte Daten zu speichern.

**Claims**

1. A method for coding (k, r) data comprising steps consisting in:

    - dividing (302) an initial datum a into k data blocks $a_i$ of the same size;
    - grouping (304) the k data blocks into r-1 disconnected subsets $S_j$ of data blocks;
    - generating (606), for each subset $S_j$, a linear function $g_j(a)$ defined as a linear combination of the data blocks assigned to said sub-block $S_j$; and
    - generating (604) r parity functions comprising a primary parity function $f_0(a)$ as a linear combination of the k data blocks $a_i$, and r-1 secondary parity functions, each secondary parity function $f_j(a)$ being defined as the sum of the primary parity function $f_0(a)$ and of a linear function $g_j(a)$, wherein the step of generating (308) r parity functions consists in generating (306) r encoding vectors comprising:

- a primary encoding vector $C_0$ composed of k primary encoding coefficients $c_{0,i}$ to $c_{0,k}$ in which each primary encoding coefficient $c_{0,i}$ corresponds to a non-zero random number; and
- r-1 secondary encoding vectors $C_j$ (1<=j<=r-1), each secondary encoding vector being composed of k secondary encoding coefficients $c_{j,1}$ to $c_{j,k}$ in which a secondary encoding coefficient $c_{j,i}$ corresponds to a non-zero or zero random number depending on whether the data block $a_i$ belongs to or does not belong to the subset $S_j$.

2. The method according to claim 1, wherein the step of generating a linear function $g_j(a)$ consists in generating a linear combination from the k data blocks $(a_1, ..., a_k)$ and from the k secondary encoding coefficients $c_{j,1}$ to $c_{j,k}$ of the secondary encoding vector $C_j$.

3. The method according to claim 1 or 2, wherein k=10 and r=4.

4. A method for storing k+r data comprising at least one step consisting in storing (204), in k systematic storage devices $N_i$, i ∈ {1, .., k}, k data blocks $a_i$, and in storing, in r parity storage devices $N_i$, i E {k+1, .., k+r}, r parity functions, the r parity functions being obtained according to the data coding method of any one of claims 1 to 3.

5. A device for coding data comprising means suitable for implementing the steps of the data coding method according to any one of claims 1 to 3.

6. A method for reconstructing the content of a storage device out of a plurality of devices storing k data blocks $a_i$ in k systematic storage devices $N_i$, iE {1, .., k}, and r parity functions $f_j(a)$ in r parity storage devices $N_i$, i E {k+1, .., k+r}, said k data blocks and r parity functions being obtained according to the method of any one of claims 1 to 3, the reconstruction method comprising at least steps consisting in:

   - determining (700) whether the storage device for which to reconstruct the content is a systematic or parity storage device;
   - if said device is a systematic storage device $N_i$, i ∈ {1, .., k}:
   - determining (716) to which data subset $S_j$ the data block of said device belongs;
   - retrieving (718) the primary and secondary parity functions stored in the parity storage devices k+1 and k+1+j;
   - computing (720) the linear function $g_j(a)$ associated with the subset $S_j$;
   - retrieving (722) the data blocks of the subset $S_j$ except for the block $a_i$; and
   - reconstructing (724) the content of said systematic storage device $N_i$, i E {1, .., k};
   - if said device is a parity storage device $N_i$, i ∈ {k+1, .., k+r}, determining (726) the index i identifying said storage device;
   - if the index i is equal to k+1:

      ■ retrieving (728) the secondary parity function $f_1(a)$ stored in the parity storage device of index i=k+2 and the data blocks $a_i$ of the subset $S_1$;
      ■ computing (730) the linear function $g_1(a)$ associated with the subset $S_1$ and decoding the primary parity function $f_0(a)$; and
      ■ reconstructing (732) the content of said parity device of index i=k+1;

   - if the index i is greater than k+1:

      ■ retrieving (734) the primary parity function $f_0(a)$ stored in the parity storage device of index i=k+1 and the data blocks $a_i$ of the subset $S_{i-k+1}$;
      ■ computing (736) the linear function $g_{i-k+1}(a)$ associated with the subset $S_{i-k+1}$ and decoding the secondary parity function $f_{i-k+1}(a)$; and
      ■ reconstructing (738) the content of said parity device of index i>k+1.

7. The method according to claim 6, wherein the steps of retrieving the parity functions consist in transferring the data from the corresponding storage devices to a data collecting device.

8. The method according to claim 6 or 7, wherein the step of computing the linear function $g_j(a)$ associated with the subset $S_j$ for the reconstruction of a systematic node i such that i E {1, .., k}, consists in subtracting the primary parity function stored in the storage device $N_{k+1}$ from the secondary parity function stored in the storage device $N_{k+1+j}$.

9. The method according to any one of claims 6 to 8, wherein the step of computing the linear function $g_1(a)$, associated with the subset $S_1$ for the reconstruction of a parity node i such that i=k+1, consists in generating a linear combination from the data blocks of the subset $S_1$ and from the encoding vector $C_1$, and the step of computing the linear function $g_j(a)$, associated with the subset $S_j$ for the reconstruction of a parity node i such that i E {k+2, .., k+r}, consists in generating a linear combination from the data blocks of the subset $S_j$ and from the encoding vector $C_j$.

10. The method according to any one of claims 6 to 9, wherein the step of reconstructing the content of said systematic storage device consists in decoding the data block $a_i$ from the linear function $g_j(a)$.

11. The method according to any one of claims 6 to 9, wherein the step of reconstructing the content of said parity storage device i such that i=k+1 consists in decoding the secondary parity function of said parity device of index i=k+1 from the computed linear function $g_1(a)$, and the step of reconstructing the content of said parity storage device i such that i>k+1 consists in decoding the secondary parity function of said parity device of index i>k+1 from the computed linear function $g_{i-k+1}(a)$.

12. A device for reconstructing the content of a storage device out of a plurality of devices storing k data blocks $a_i$ in k systematic storage devices $N_i$, I ∈ { 1, .., k}, and r parity functions $f_j(a)$ in r parity storage devices $N_i$, i ∈ {k+1, .., k+r}, said k data blocks and r parity functions being obtained according to the method of any one of claims 1 to 3, the device comprising means suitable for implementing the steps of the method for reconstructing the content of a storage device according to any one of claims 6 to 11.

13. A computer program product comprising a program, said program comprising code instructions making it possible to perform the steps of the method according to any one of claims 1 to 3, and/or comprising code instructions making it possible to perform the steps of the method according to any one of claims 6 to 11, when said program is run on a computer.

14. An integrated circuit of ASIC or FPGA type comprising at least one device according to claim 5 and/or according to claim 12.

15. The use of the content reconstruction method according to any one of claims 6 to 11 in a distributed storage system, said distributed storage system comprising a plurality of data storage nodes capable of storing data coded according to the coding method of any one of claims 1 to 3.

16. The use of the content reconstruction method according to any one of claims 6 to 11 in a local storage system, said local storage system comprising data storage discs capable of storing data coded according to the coding method of any one of claims 1 to 3.

**FIG.1**

FIG. 2

<u>300</u>

Paramètres (k=10, r=4)

↓

Diviser donnée initiale a en k = 10
blocs de données $a_i$ (1<=i<=10)

302

↓

Regrouper les blocs de données $a_i$  (1<=i<=10)
en r-1 = 3 sous-ensembles $S_1$, $S_2$ et $S_3$

304

↓

Générer les vecteurs d'encodage :
$C_0$ et Cj (1<=j<=3)

306

↓

Générer les fonctions de parité  :
$f_0(a)$ et  $f_j$ (a) (1<=j<=3)

308

↓

Fin

**FIG. 3**

FIG.4

FIG.5

FIG.6

<u>700</u>

**702**

Détection panne

**704**

2,3,4 Pannes

Nombre de pannes

>=5 Pannes

**708**

1 Panne

**706**

Réparation classique

Arrêt système

**710**

Nœud systématique

Type de nœud en panne

Nœud de parité

**712**

**714**

Vers Fig.7b Reconstruction d'un nœud systématique

Vers Fig.7c Reconstruction d'un nœud de parité

**FIG.7a**

de Fig. 7a
Panne d'un nœud
systématique $N_i$, i ∈ [1,10]

716

Déterminer sous-ensemble $S_j$ (j ∈ [1,2,3]) auquel appartient le bloc de données $a_i$ du nœud $N_i$ en panne

718

Charger les blocs de données du nœud $N_{k+1}$ et du nœud $N_{k+1+j}$

720

Calculer $g_j$ (a), j ∈ [1,2,3]

722

Charger les blocs de données du sous-ensemble $Sj\backslash\{a_i\}$

724

Reconstruire le nœud $N_i$

**FIG.7b**

de Fig. 7a
Panne d'un nœud de
parité $N_i$, $i \in [11,14]$

726

$i \in [12,14]$ ⟷ Identifiant du nœud ⟷ $i = 11$

734

Charger les données
du nœud $N_{11}$ et du
sous-ensemble $S_{i-11}$

736

Calculer $g_{i-11}(a)$ et
décoder $f_{i-11}(a)$

738

Reconstruire
le nœud $N_i$ ,
$i \in [12,14]$

728

Charger les données
du nœud $N_{12}$ et du
sous-ensemble $S_1$

730

Calculer $g_1(a)$ et
décoder $f_0(a)$

732

Reconstruire
le nœud $N_{11}$

FIG.7c

802 804 806 808 810

| Code | Efficacité de Stockage | Bande passante | Lecture Entrée/Sortie | Tolérance aux pannes |
|---|---|---|---|---|
| Code RS | 71% | 100% | 100% | 4 pannes quelconques parmi 14 noeuds |
| Code Régénérateurs | 71% | 32.5% | 100% | 4 pannes quelconques parmi 14 noeuds |
| Code Régénérateurs exacts | 71% | 32.5% | 100% | 4 pannes quelconques parmi 14 noeuds |
| Code Hiérarchique | 71% | 33,57% | 33,57% | Ne tolère pas 4 pannes quelconques parmi les 14 noeuds |
| Code Hitchhicker | 71% | 76,42% | 76,42% | 4 pannes quelconques parmi 14 noeuds |
| Code Babylon | 71% | 43,57% | 43,57% | 4 pannes quelconques parmi 14 noeuds |

800

**FIG.8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016211869 A1, Blaum Mario

**Littérature non-brevet citée dans la description**

- **ALEXANDROS G DIMAKIS ; P BRIGHTEN GODFREY ; YUNNAN WU ; MARTIN J WAINWRIGHT ; KANNAN RAMCHANDRAN.** Network coding for distributed storage systems. *IEEE Transactions on Information Theory,* 2010, vol. 56 (9), 4539-4551
- **RASHMI ; KORLAKAI ; VINAYAK ; NIHAR B. SHAH ; P. VIJAY KUMAR.** Optimal exact-regenerating codes for distributed storage at the MSR and MBR points via a product-matrix construction. *IEEE Transactions on Information Theory,* 2011, vol. 57 (8), 5227-5239
- **ALESSANDRO DUMINUCO ; ERNST BIERSACK.** Hierarchical codes: How to make erasure codes attractive for peer-to-peer storage systems. *P2P'08, 8th IEEE International Conférence on Peer-to-Peer Computing,* 89-98

- **KV RASHMI ; NIHAR B SHAH ; DIKANG GU ; HAIRONG KUANG ; DHRUBA BORTHAKUR ; KANNAN RAMCHANDRAN.** A hitchhiker's guide to fast and efficient data reconstruction in erasure-coded data centers. *ACM SIGCOMM Computer Communication Review,* 2015, vol. 44 (4), 331-342
- **CHENG HUANG et al.** Erasure Coding in Windows Azure Storage. *USENIX,* 11 Avril 2013, 1-12
- Pyramid Codes : Flexible Schemes to Trade Spaces for Access Efficiency in Reliable Data Storage systems. **CHENG HUANG et al.** Proc. Sixth IEEE International Symposium on Network Computing and Applications 2007. IEEE, 01 Juillet 2007, 79-86